# EUROPÄISCHE PATENTSCHRIFT

(11) **EP 4 182 974 B1**
(45) Veröffentlichungstag und Bekanntmachung des Hinweises auf die Patenterteilung: **12.02.2025**
(21) Anmeldenummer: 20750605.6
(22) Anmeldetag: 16.07.2020
(51) Int. Cl.: H01L 31/05, H01L 31/054, H01L 31/048

(54) **PHOTOVOLTAIKBAUTEIL**
PHOTOVOLTAIC COMPONENT
COMPOSANT PHOTOVOLTAÏQUE

(43) Veröffentlichungstag der Anmeldung: 24.05.2023
(73) Patentinhaber: FOXLED1 AG, 6331 Hünenberg (CH)
(72) Erfinder: SCHIBLI, Peter, 6331 Hünenberg (CH)
(74) Vertreter: E. Blum & Co. AG
(86) Internationale Anmeldenummer: PCT/EP2020/070229
(87) Internationale Veröffentlichungsnummer: WO 2021/151523

(56) Entgegenhaltungen:
- EP-A1- 2 482 333
- WO-A1-2018/138548
- US-A1- 2011 263 066
- US-A1- 2014 261 631
- US-A1- 2015 256 124
- US-A1- 2017 200 848

## Beschreibung

### Gebiet der Erfindung

Die Erfindung betrifft ein Photovoltaikbauteil.

Die Erfindung betrifft ausserdem Gebäude und Vorrichtungen mit einem Photovoltaikbauteil sowie Verwendungen des Photovoltaikbauteils.

### Hintergrund

Photovoltaik ist die Umwandlung von Lichtenergie, meist aus Sonnenlicht, in elektrische Energie mittels Solarzellen bzw. Photovoltaikzellen.

Die Konzentrator-Photovoltaik verwendet Linsen und/oder Reflektoren, um das Sonnenlicht auf Photovoltaikzellen zu konzentrieren. Dies ermöglicht eine Verringerung der Zellgröße. Die Energieumwandlung wird in der Regel von einer speziellen Hochleistungs-Solarzelle durchgeführt, insbesondere mittels hocheffizienten Mehrfach (Multi-Junction) Solarzellen aus beispielsweise III-V Halbleitermaterialien.

Konzentrator-Photovoltaik Systeme werden nach der Menge ihrer Sonnenkonzentration kategorisiert, gemessen in "Sonnen". Dabei unterscheidet man niedrigkonzentrierte Systeme, Systeme mit mittlerer Konzentration und hochkonzentrierte Systeme.

Eine steigende Konzentration erhöht in der Regel auch die Komplexität des Systems. Insbesondere steigen die Anforderungen an die Kühlung und die Optik.

Niedrigkonzentrierte Systeme verfügen oft über einen einfachen Booster-Reflektor, der die solare elektrische Leistung aber teilweise bereits um mehr als 30% gegenüber Nicht-Konzentrator-Systemen erhöhen kann.

Hochkonzentrierte Systeme dagegen verwenden komplexere optische Systeme. Diese können z.B. aus einer Fresnel-Linse als primäre Optik und einem Reflektor als sekundäre Optik bestehen.

Für flächige Anwendungen sind zudem Solarmatten bekannt, welche sich flexibel an diversen Flächen von Gebäuden oder Vorrichtungen anbringen lassen. Solche Solarmatten, z.B. basierend auf Cadmiumtellurid oder CIGS haben allerdings einen begrenzten Wirkungsgrad.

Insgesamt bleibt es eine Herausforderung, Photovoltaik-Systeme, insbesondere Konzentrator-Photovoltaik Systeme, in effizienter Weise und mit hohem Wirkungsgrad in Gebäude oder Vorrichtungen zu integrieren und eine hohe Solarleistung zu generieren.

US 2017/200848 A1 zeigt eine hochkonzentrierte Photovoltaikvorrichtung mit einer Fresnel-Linse sowie einem Spiegel hinter der Fresnel-Linse, der der Fresnel-Linse zugewandt ist. Zudem bildet eine Sekundärlinse eine Einheit mit der Fresnel-Linse und ist dem Spiegel zugewandt. Zwei optische Elemente bilden einen Köhler-Integrator zwischen einer entfernten Quelle vor dem Gerät und einer Photovoltaikzelle als Ziel.

US 2015/256124 A1 zeigt ein Verfahren und eine Vorrichtung zum Kalibrieren eines Reflektors in einer Solaranlage. US 2015/256124 A1 und US 2014/261631 A1 offenbaren weitere hochkonzentrierte Photovoltaikvorrichtungen.

### Darstellung der Erfindung

Es ist daher eine Aufgabe von Ausführungsformen der vorliegenden Erfindung, ein Photovoltaikbauteil zu schaffen, welche Nachteile des Bekannten vermeidet.

Eine weitere Aufgabe von Ausführungsformen der vorliegenden Erfindung besteht darin, ein Photovoltaikbauteil zu schaffen, welches eine verbesserte Ausnutzung der Sonnenenergie ermöglicht, und dies insbesondere in kostengünstiger und effizienter Weise sowie mit vorteilhaftem Wirkungsgrad.

Ein erster Aspekt der Erfindung betrifft ein Photovoltaikbauteil gemäss Anspruch 1.

Dementsprechend weist das Photovoltaikbauteil eine äussere Scheibe und eine innere Scheibe auf. Zwischen der äusseren Scheibe und der inneren Scheibe ist eine energieerzeugende Schicht mit einer Mehrzahl von Konzentrator-Photovoltaikmodulen angeordnet. Die Konzentrator-Photovoltaik-Module weisen eine Kondensoroptik als primäre Optik, eine teiltransparente Umlenkoptik als sekundäre Optik und einen Photovoltaik-Chip, der in ein oberflächenmontierbares Gehäuse integriert ist, auf. Das oberflächenmontierbare Gehäuse weist eine transparente Abdeckung und einen integrierten Reflektor als tertiäre Optik auf. Die Kondensoroptik ist zwischen der äusseren Scheibe und dem Photovoltaik-Chip angeordnet, während die teiltransparente Umlenkoptik zwischen dem Photovoltaik-Chip und der inneren Scheibe angeordnet ist. Die transparente Abdeckung und eine unter der transparenten Abdeckung angeordnete Eintrittsöffnung des integrierten Reflektors sind der inneren Scheibe zugewandt.

Ein derartiges Photovoltaikbauteil kann in effizienter und zuverlässiger Weise gefertigt werden. Zudem kann durch die Integration der energieerzeugenden Schicht zwischen die äussere und die innere Scheibe eine hohe Lebensdauer und Zuverlässigkeit der energieerzeugenden Schicht erzielt werden. So schützen die innere und die äussere Scheibe die energieerzeugende Schicht vor Umwelteinflüssen.

Gemäss Ausgestaltungen der Erfindung sind somit Konzentrator-Photovoltaik-Module in das Photovoltaikbauteil integriert. Dies ermöglicht einen hohen Wirkungsgrad, insbesondere im Vergleich zu Solarfolien aus beispielsweise Cadmium-Tellurid.

Die Integration des Photovoltaik-Chips in ein oberflächenmontierbares Gehäuse ermöglicht eine effiziente (Vor)Produktion des Photovoltaik-Chips in sehr grossen Stückzahlen. Gleichzeitig ist in das Gehäuse des Chips schon ein Reflektor integriert. Derartige oberflächenmontierbare Module, welche auch als SMD-Module (Surface Mounted Device) bezeichnet werden, können in besonders effizienter und automatisierter Weise montiert und verarbeitet werden. Insbesondere können die oberflächenmontierbaren Gehäuse mit den integrierten Photovoltaik-Chips und den integrierten Reflektoren in effizienter Weise auf das jeweilige Trägermaterial der jeweiligen Anwendung, z.B. auf eine Trägerfolie, mittels Reflow-Löten aufgebracht werden.

Gemäss Ausführungsformen der Erfindung weisen die Konzentrator-Photovoltaik-Module eine dreistufige Optik auf. Dadurch kann ein erhöhter Wirkungsgrad erzielt werden.

Hierbei ist die Kondensoroptik dazu konfiguriert, durch die äussere Scheibe einfallendes Sonnenlicht auf einen oder mehrere Umlenkbereiche der Umlenkoptik zu fokussieren bzw. zu konzentrieren. Die Umlenkoptik lenkt dann das so fokussierte bzw. gesammelte Licht in den integrierten Reflektor um und der Reflektor wiederum konzentriert das von der Umlenkvorrichtung umgelenkte Sonnenlicht auf den Photovoltaik-Chip.

Gemäss Ausführungsformen ist die Umlenkoptik dabei zwischen der inneren Scheibe und dem oberflächenmontierbaren Gehäuse mit dem Photovoltaik-Chip angeordnet und die transparente Abdeckung des oberflächenmontierbaren Gehäuses ist der inneren Scheibe zugewandt oder mit anderen Worten nach unten gerichtet bzw. an der der Sonne abgewandten Seite angeordnet. Unter der transparenten Abdeckung ist eine Eintrittsöffnung des integrierten Reflektors vorgesehen. Der Reflektor konzentriert bzw. sammelt das umgelenkte Sonnenlicht und leitet es durch eine Austrittsöffnung auf den Photovoltaik-Chip.

Hierbei beziehen sich die Begriffe «unter» bzw. «unterhalb» und «ober» bzw. «oberhalb» auf die Sonne bzw. den Verlauf des einfallenden Sonnenlichts.

Gemäss Ausführungsformen ist wenigstens einer der einen oder der mehreren Umlenkbereiche seitlich versetzt zu dem oberflächenmontierbaren Gehäuse angeordnet. Dadurch ist es möglich, das einfallende Sonnenlicht am oberflächenmontierbaren Gehäuse vorbei auf die Umlenkvorrichtung zu leiten und dann zurück auf die transparente Abdeckung des oberflächenmontierbaren Gehäuses umzulenken. Dadurch kann der Wirkungsgrad erhöht werden.

Gemäss einer Ausgestaltung der Erfindung ist die Umlenkvorrichtung dazu konfiguriert, eine mehrstufige Umlenkung des Sonnenlichts in den integrierten Reflektor vorzunehmen. Mit anderen Worten wird das Licht nicht direkt von dem ersten Umlenkbereich, auf den das von der Kondensoroptik fokussierte Licht fällt, umgelenkt. Sondern es folgen noch eine oder mehrere weitere Umlenkungen mittels der Umlenkvorrichtung, bevor das umgelenkte Licht durch die transparente Abdeckung in den integrierten Reflektor geleitet wird.

Die eine oder die mehreren Umlenkbereiche können insbesondere als reflektierende Flächen ausgebildet sein. Die reflektierenden Flächen können beispielsweise reflektierende Beschichtungen der Umlenkvorrichtung sein. Die reflektierenden Flächen können gemäss Ausführungsformen als spiegelnde Flächen ausgebildet sein.

Gemäss Ausführungsformen kann die Totalreflexion zur Umlenkung des Lichts genutzt werden.

Gemäss einer weiteren Ausgestaltung der Erfindung kann die Umlenkvorrichtung auch einen Lichtwellenleiter aufweisen. Dieser kann insbesondere dazu ausgestaltet sein, das von einer ersten Umlenkvorrichtung reflektierte Licht zu empfangen und in den integrierten Reflektor weiterzuleiten. Dabei kann an den Grenzflächen des Lichtwellenleiters die Totalreflexion genutzt werden.

Gemäss einer Ausgestaltung der Erfindung weist das Photovoltaik-Bauteil eine Lichtdurchlässigkeit von mehr als 50%, insbesondere von mehr als 75%, auf. Damit werden die Anwendungsbereiche des Photovoltaik-Bauteils erweitert. Insbesondere kann das Photovoltaik-Bauteil damit z.B. als Fenster eingesetzt werden oder auch für andere Anwendungen, bei denen der Bereich hinter bzw. unter der inneren Scheibe mit Sonnenlicht versorgt werden soll bzw. muss. Die Lichtdurchlässigkeit bzw. Transparenz bezieht sich dabei insbesondere auf den für das menschliche Auge sichtbaren Spektralbereich.

Gemäss einer weiteren Ausgestaltung der Erfindung decken der Umlenkbereich bzw. die Umlenkbereiche der Umlenkoptik maximal 20%, insbesondere maximal 15%, der horizontalen Querschnittsfläche des Photovoltaik-Bauteils ab. Insbesondere wenn die Umlenkbereiche als reflektierende, insbesondere spiegelnde und somit lichtundurchlässige bzw. weitgehend lichtundurchlässige Flächen ausgebildet sind, kann dadurch erreicht werden, dass das Photovoltaik-Bauteil dennoch teil-transparent ist.

Gemäss einer weiteren Ausgestaltung der Erfindung weist die Kondensoroptik der Konzentrator-Photovoltaik-Module mehrere Kondensorlinsen auf, welche nebeneinander angeordnet sind. Dabei sind gemäss Ausgestaltungen der Erfindung die Kondensorlinsen insbesondere rotationssymmetrisch zu einer zentralen Achse des Konzentrator-Photovoltaik-Moduls angeordnet. Ein derartiges Modul ermöglicht es, das Sonnenlicht auf verschiedene Bereiche der Umlenkvorrichtung zu fokussieren. Dies ermöglicht zusätzliche vorteilhafte Gestaltungen des Photovoltaik-Bauteils.

Gemäss einer weiteren Ausgestaltung der Erfindung ist wenigstens eine der Kondensorlinsen in einem Winkel, insbesondere einem fünften Winkel, gegenüber einer horizontalen Ebene des Photovoltaikbauteils geneigt angeordnet. Dies ermöglicht eine erhöhte Lichtausbeute und damit einen erhöhten Wirkungsgrad. Insbesondere ist es bei einer derartigen Ausgestaltung der Erfindung möglich, die wenigstens zwei Kondensorlinsen unterschiedlich in Bezug auf die Elevation auszurichten und damit eine für jeweils unterschiedliche Sonnenstände ausgerichtete Kondensorlinse vorzusehen.

Es ist hierbei zu beachten, dass der Begriff horizontale Ebene des Photovoltaik-Bauteils sich auf die Grundfläche des Bauteils bezieht und somit insbesondere parallel zu der inneren und der äusseren Scheibe verlaufen soll. Der Begriff horizontale Ebene des Photovoltaik-Bauteils soll sich somit nicht notwendigerweise auf die jeweilige Einbausituation des Photovoltaik-Bauteils beziehen. So kann z.B. bei einem senkrechten Einbau des Photovoltaik-Bauteils, z.B. als Fenster in einem Gebäude, die horizontale Ebene des Photovoltaik-Bauteils senkrecht zu dem Boden des Gebäudes verlaufen.

Gemäss einer Ausgestaltung weist das Photovoltaik-Bauteil eine erste Kondensorlinse auf, welche in dem fünften Winkel gegenüber der horizontalen Ebene des Photovoltaikbauteils geneigt angeordnet ist und eine zweite Kondensorlinse auf, welche in bzw. parallel zu der horizontalen Ebene des Photovoltaikbauteils angeordnet ist. Bei einer derartigen Ausgestaltung ist die erste Kondensorlinse insbesondere dazu vorgesehen, das Sonnenlicht am Morgen und am Nachmittag optimal einzufangen und zu fokussieren und die zweite Kondensorlinse ist insbesondere dazu vorgesehen, das Sonnenlicht am Mittag (Sonnenhöchststand) optimal einzufangen und zu fokussieren.

Die äussere Scheibe und die innere Scheibe weisen vorzugsweise eine hohe Transmission auf.

Gemäss einer Ausführungsform der Erfindung können die äussere Scheibe und/oder die innere Scheibe aus Glas bestehen und somit als Glasbauteil ausgeführt sein. Gemäss einer weiteren Ausführungsform der Erfindung können die äussere Scheibe und/oder die innere Scheibe aus einem Kunststoff bestehen und somit als Kunststoffbauteil ausgeführt sein.

Gemäss Ausführungsformen der Erfindung werden mit einer Scheibe allgemein flächenförmige, insbesondere schichtförmige Elemente bezeichnet, die insbesondere transparent oder teilweise transparent ausgeführt sind. Eine Scheibe kann gemäss Ausführungsformen der Erfindung somit auch als Schicht bezeichnet werden, insbesondere als transparente oder teilweise transparente Schicht. Eine Scheibe kann gemäss Ausführungsformen der Erfindung verschiedenste an die jeweilige Einbaulage angepasste Geometrien aufweisen. Gemäss Ausführungsformen kann eine Scheibe insbesondere rechteckförmig oder quadratisch ausgeführt sein. Gemäss Ausführungsformen der Erfindung ist eine Scheibe insbesondere starr bzw. steif ausgeführt.

Gemäss einer weiteren bevorzugten Ausgestaltung der Erfindung weist das Gehäuse eine eine Aufnahmewanne bildende Aussparung mit einem vertieften Bodenabschnitt zur Aufnahme des Photovoltaik-Chips auf, wobei die Aufnahmewanne Seitenwände mit reflektierenden Bereichen aufweist, die den Reflektor bilden.

Gemäss einer Ausgestaltung weist die Aufnahmewanne Seitenwände mit wenigstens einem ersten und einem zweiten reflektierenden Bereich auf, wobei der erste reflektierende Bereich in einem ersten Winkel gegenüber einer horizontalen Ebene des Gehäuses ausgerichtet ist und der zweite reflektierende Bereich in einem zweiten Winkel gegenüber der horizontalen Ebene des Gehäuses ausgerichtet ist. Der erste Winkel ist dabei unterschiedlich zu dem zweiten Winkel.

Ein derart ausgestaltetes Konzentrator-Photovoltaik-Modul ermöglicht es, die beiden unterschiedlichen Winkel des ersten reflektierenden Bereichs und des zweiten reflektierenden Bereichs individuell zu wählen und an die jeweiligen äusseren Gegebenheiten, insbesondere die jeweilige Ausrichtung der zum Einbau vorgesehenen Flächen und die jeweilige Sonnenexposition der zum Einbau vorgesehenen Flächen zu berücksichtigen. Der erste und der zweite reflektierende Bereich bilden reflektierende Flächen, welche das Sonnenlicht über die transparente Abdeckung empfangen, reflektieren und in Richtung des Photovoltaik-Chips weiterleiten bzw. es auf den Photovoltaik-Chip konzentrieren. Somit bilden die wenigstens zwei reflektierenden Bereiche der Aufnahmewanne einen Reflektor.

Es ist hierbei zu beachten, dass der Begriff horizontale Ebene des Gehäuses sich auf die Grundfläche bzw. Bodenfläche des Gehäuses bezieht und insbesondere parallel zu der Bodenfläche des Gehäuses verlaufen soll. Der Begriff horizontale Ebene des Gehäuses soll sich somit nicht notwendigerweise auf die jeweilige Einbausituation des Gehäuses beziehen. So kann z.B. bei einem senkrechten Einbau des Gehäuses in einem Gebäude die horizontale Ebene des Gehäuses senkrecht zu dem Boden des Gebäudes verlaufen.

Gemäss Ausgestaltungen der Erfindung können somit die Winkel der verschiedenen Reflexionsbereiche jeweils individuell an die jeweilige Einbausituation in dem Gebäude angepasst werden. Insbesondere können die Winkel der Reflexionsbereiche in Bezug auf die Elevation und/oder den Azimut angepasst werden.

Durch die unterschiedlichen Winkel des ersten reflektierenden Bereichs und des zweiten reflektierenden Bereichs kann die Konzentrations- bzw. Reflexionswirkung und der Wirkungsgrad des Konzentrator-Photovoltaik-Moduls und des Photovoltaikbauteils in einfacher, kostengünstiger und effizienter Weise erhöht werden.

Die transparente Abdeckung des oberflächenmontierbaren Gehäuses besteht vorzugsweise aus Glas, insbesondere aus Dünnglas, z.B. Gorilla^{®}-Glas oder ultradünnem Glas. Gemäss einer anderen Ausführungsform kann die transparente Abdeckung aus Kunststoff bestehen. Die transparente bzw. lichtdurchlässige Abdeckung lässt gemäss bevorzugten Ausführungsformen das Sonnenlicht möglichst ungehindert in den Reflektor der Aufnahmewanne passieren und ist daher gemäss Ausführungsformen als plane Fläche ausgebildet. Im Querschnitt ist die transparente Abdeckung insbesondere rechteckig, wobei die Dicke der Abdeckung möglichst klein gewählt ist, beispielsweise 0.01 mm bis 1 mm.

Gemäss weiteren Ausführungsformen kann die transparente Abdeckung aber auch eine konkave oder konvexe Form aufweisen und das Sonnenlicht somit umlenken und/oder fokussieren.

Der Photovoltaik-Chip kann gemäss Ausführungsformen als Einfach- oder als Mehrfachsolarzelle ausgebildet sein, insbesondere als 3-fach Solarzelle ("triple-junction") oder Vierfach-Solarzelle ("quadrupeljunction"). Gemäss besonders bevorzugten Ausführungsformen ist der Photovoltaik-Chip eine Mehrfachsolarzelle aus einem III-V Halbleitermaterial, z.B. aus Galliumarsenid (GaAs) oder Galliumantimonid (GaSb). Der Photovoltaik-Chip ist insbesondere als ein photovoltaischer DIE, d.h. ein ungehäustes Stück eines Halbleiter-Wafers, ausgeführt.

Gemäss einer weiteren vorteilhaften Ausgestaltung der Erfindung weist das Photovoltaikbauteil eine Kontaktierungsschicht mit Leiterbahnen zur Kontaktierung der Konzentrator-Photovoltaikmodule bzw. des Photovoltaik-Chips auf. Die Kontaktierungsschicht stellt eine Leiterplatte bzw. einen Träger für die Konzentrator-Photovoltaik-Module dar. Die Kontaktierungsschicht kann insbesondere als eine Beschichtung auf der Scheibe oder als eine flexible Folie ausgebildet sein.

Gemäss einer Ausgestaltung der Erfindung sind die Konzentrator-Photovoltaikmodule und die Kondensorlinsen in ein Kunststoffmaterial integriert, insbesondere in ein transparentes Kunststoffmaterial.

Gemäss einer weiteren bevorzugten Ausgestaltung der Erfindung ist die energieerzeugende Schicht mittels einer äusseren und einer inneren Verbundschicht aus Kunststoff zwischen der äusseren und der inneren Scheibe integriert. Die Verbundschicht kann vorteilhaft eine Kunststofffolie, insbesondere aus PVB oder EVA, oder ein anderer Kunststoff, z.B. PU oder ein Acrylat oder ein anderes Kunststoffharz sein.

Gemäss einer bevorzugten Ausgestaltung der Erfindung sind die einzelnen Komponenten des Photovoltaikbauteils, insbesondere das oberflächenmontierbare Gehäuse, die Konzentrator-Photovoltaikmodule und die Kontaktschicht, transparent oder weitgehend transparent ausgebildet.

Gemäss einer weiteren vorteilhaften Ausgestaltung der Erfindung ist hinter der energieerzeugenden Schicht eine wärmeabsorbierende Folie angeordnet. Dies kann beispielsweise eine Aufheizung des Gebäudeinneren vermindern.

Gemäss einer weiteren vorteilhaften Ausgestaltung der Erfindung ist hinter der energieerzeugenden Schicht eine wärmeableitende Folie angeordnet ist. Dies kann ebenfalls eine Aufheizung des Gebäudeinneren sowie die Aufheizung des Photovoltaikbauteils vermindern.

Die wärmeabsorbierende Folie und/oder die wärmeableitende Folie können insbesondere unter der inneren Scheibe oder zwischen der inneren Scheibe und der energieerzeugenden Schicht angeordnet sein.

Gemäss einer weiteren vorteilhaften Ausgestaltung der Erfindung ist die Kontaktierungsschicht als wärmeableitende Schicht oder Folie ausgebildet. Hierbei können insbesondere die metallischen Leiterbahnen zur Wärmeableitung genutzt werden.

Gemäss einer Ausführungsform der Erfindung ist der Photovoltaik-Chip in Bezug auf wenigstens eine vertikale Symmetrieebene des Gehäuses asymmetrisch angeordnet. Mittels einer derartigen asymmetrischen Anordnung des Photovoltaik-Chips in dem Gehäuse lassen sich unterschiedlichen Winkel des ersten und des zweiten reflektierenden Bereichs besonders effizient und platzsparend in dem Gehäuse realisieren.

Gemäss einer weiteren Ausführungsform der Erfindung liegen sich der erste und der zweite reflektierende Bereich in Bezug auf eine erste vertikale Symmetrieebene des Photovoltaik-Chips gegenüber. Mit anderen Worten, der erste und der zweite reflektierende Bereich sind an gegenüberliegenden Seiten des Photovoltaik-Chips angeordnet.

Eine derartige Ausführungsform mit sich gegenüberliegenden reflektierenden Flächen mit unterschiedlichen Winkeln ermöglicht eine verbesserte Konzentration des Sonnenlichts auf den Photovoltaik-Chip, insbesondere bei Sonnenlicht, welches nicht parallel zu der ersten vertikalen Symmetrieebene des Photovoltaik-Chips einfällt.

Gemäss einer Ausführungsform der Erfindung unterscheiden sich der erste Winkel und der zweite Winkel um wenigstens 10°, insbesondere um wenigstens 20° voneinander.

Derartig ausgebildete unterschiedliche Winkel sind insbesondere dann vorteilhaft, wenn die Sonneneinstrahlung nicht senkrecht bzw. symmetrisch in Bezug auf die Senkrechte auf das Konzentrator-Photovoltaik-Modul fällt. Bei derartigen Gegebenheiten ermöglichen derart unterschiedliche Winkel eine verbesserte optische Konzentrationswirkung des Reflektors.

Gemäss einer Ausführungsform der Erfindung sind der erste reflektierende Bereich und der zweite reflektierende Bereich als reflektierende Beschichtung der Aufnahmewanne ausgebildet. Eine derartige Beschichtung kann gemäss Ausführungsformen z.B. mittels eines entsprechenden Beschichtungsverfahrens auf einem Basiskörper des oberflächenmontierbaren Gehäuses aufgebracht werden.

Gemäss einer weiteren Ausführungsform der Erfindung sind der erste reflektierende Bereich und der zweite reflektierende Bereich als reflektierende Folie ausgebildet.

Eine derartige reflektierende Folie, z.B. eine Metallfolie, kann gemäss Ausführungsformen z.B. mittels eines entsprechenden Klebeverfahrens auf dem Basiskörper aus Kunststoff aufgebracht werden.

Gemäss weiteren Ausführungsformen der Erfindung weist die Aufnahmewanne Seitenwände mit einem dritten und einem vierten reflektierenden Bereich auf. Der dritte reflektierende Bereich ist in einem dritten Winkel gegenüber der horizontalen Ebene des Gehäuses ausgerichtet und der vierte reflektierende Bereich ist in einem vierten Winkel gegenüber der horizontalen Ebene des Gehäuses ausgerichtet. Gemäss weiteren Ausführungsformen ist der dritte Winkel unterschiedlich zu dem vierten Winkel.

Derartige Ausführungsformen weisen somit vier unterschiedliche Reflexionsbereiche bzw. Reflexionsflächen auf, welche jeweils mit individuellen und unterschiedlichen Winkeln gegenüber der horizontalen Ebene des Gehäuses ausgerichtet sein können.

Durch die bis zu vier unterschiedlichen Winkel des Reflektors kann für das Licht bzw. die solare Strahlung eine weitere Verbesserung der Konzentrationswirkung bzw. Reflexionswirkung des Reflektors ermöglicht.

Dementsprechend können Photovoltaikbauteile gemäss Ausführungsformen der Erfindung sowohl für vertikale Einbauflächen, z.B. für vertikale Fenster, und damit ungünstig zur Sonneneinstrahlung ausgerichtete Einbauflächen, als auch für nahezu horizontal angeordnete Einbauflächen, wie z.B. für Dachflächen gefertigt werden.

Gemäss einer Ausführungsform sind der dritte Winkel und der vierte Winkel um wenigstens 10°, insbesondere um wenigstens 20° unterschiedlich.

Gemäss Ausführungsformen der Erfindung ist das Gehäuse gegen feste Fremdkörper und gegen Flüssigkeiten geschützt. Gemäss Ausführungsformen weist das Gehäuse einen Schutzumfang gemäss dem International Protection (IP-Code) gegen feste Fremdkörper von wenigstens 5 und einen Schutzumfang gegen Flüssigkeiten von wenigstens 5 auf. Ein derart geschütztes Gehäuse gewährleistet einen zuverlässigen und langlebigen Betrieb auch bei widrigen Umweltbedingungen. Dabei kann das Gehäuse insbesondere gemäss den IP Schutzklassen 65 bis 68 geschützt sein.

Gemäss Ausführungsformen der Erfindung sind der erste reflektierende Bereich, der zweite reflektierende Bereich, der dritte reflektierende Bereich und/oder der vierte reflektierende Bereich jeweils als konkave Fläche ausgebildet.

Mittels derartiger konkaver Flächen kann die Konzentrationswirkung der reflektierenden Bereiche für das Licht bzw. die solare Strahlung erhöht werden.

Gemäss anderen Ausführungsformen der Erfindung sind der erste reflektierende Bereich, der zweite reflektierende Bereich, der dritte reflektierende Bereich und/oder der vierte reflektierende Bereich jeweils als plane Fläche ausgebildet.

Dies ist fertigungstechnisch besonders vorteilhaft.

Gemäss Ausführungsformen der Erfindung weist das Gehäuse eine integrierte Bypass-Diode, insbesondere eine Schottky-Diode, auf. Die Bypass-Diode kann insbesondere in den Basiskörper, der insbesondere aus Kunststoff bestehen kann, integriert werden. Durch eine derartige Integration der Bypass-Diode in jedes einzelne Gehäuse wird eine besonders hohe Zuverlässigkeit erzielt. Ist ein Photovoltaik-Chip defekt oder nicht voll funktionsfähig, so kann der Strom über die Bypass-Diode umgeleitet werden und die Funktionsfähigkeit des Gesamtsystems wird nicht bzw. kaum beeinträchtigt.

Ein weiterer Aspekt der Erfindung bezieht sich auf ein Gebäude oder eine Vorrichtung mit einem oder mehreren Photovoltaikbauteilen nach einem der vorhergehenden Ansprüche.

Die Vorrichtung kann insbesondere ein Fahrzeug, z.B. ein Automobil, ein Boot, ein Schiff, ein Baufahrzeug, ein Agrarfahrzeug, ein Zug oder ein Flugzeug sein. Die Vorrichtung kann ferner ein Container oder ein Gewächshaus sein.

Ein weiterer Aspekt der Erfindung bezieht sich auf die Verwendung eines Photovoltaikbauteils gemäss den obigen Ausgestaltungen zum Einbau oder Anbau in bzw. an ein Gebäude, ein Fahrzeug, einen Container, ein Gewächshaus sowie andere Vorrichtungen.

Ein weiterer Aspekt der Erfindung bezieht sich auf die Verwendung eines Photovoltaikbauteils gemäss Ausführungsformen der Erfindung zum Anbringen auf Agrarflächen.

### Kurze Beschreibung der Zeichnungen

Weitere Ausgestaltungen, Vorteile und Anwendungen der Erfindung ergeben sich aus den abhängigen Ansprüchen und aus der nun folgenden Beschreibung anhand der Figuren. Dabei zeigen:
FIG. 1a eine Querschnittsansicht eines energieerzeugenden Photovoltaikbauteils gemäss einer Ausführungsform der Erfindung;
FIG. 1b eine Querschnittsansicht eine energieerzeugenden Photovoltaikbauteils gemäss einer weiteren Ausführungsform der Erfindung;
FIG. 2 eine vergrösserte Darstellung eines Konzentrator-Photovoltaik-Moduls gemäss einer Ausführungsform der Erfindung;
FIG. 3 eine vergrösserte Darstellung eines Konzentrator-Photovoltaik-Moduls gemäss einer Ausführungsform der Erfindung mit einer mehrstufigen Umlenkung bzw. Reflexion;
FIG. 4 ein Konzentrator-Photovoltaik-Modul mit mehreren Kondensorlinsen;
FIG. 5 eine weitere Querschnittsansicht eines energieerzeugenden Photovoltaikbauteils 10 in einer x-z-Ebene gemäss einer Ausführungsform der Erfindung;
FIG. 6a eine Draufsicht auf eine Kondensoroptik gemäss den Figuren 1a, 1b, 2 und 3;
FIG. 6b eine Draufsicht auf eine Kondensoroptik 40 gemäss der Figur 4;
FIG. 6c eine Draufsicht auf eine Kondensoroptik gemäss der Figur 5;
FIG. 7 eine Querschnittsansicht eines oberflächenmontierbaren Gehäuses gemäss einer Ausführungsform der Erfindung;
FIG. 8a eine Querschnittsansicht eines oberflächenmontierbaren Gehäuses in einer x-z-Ebene;
FIG. 8b eine Querschnittsansicht des Gehäuses in einer y-z-Ebene;
FIG. 8c eine Draufsicht auf das Gehäuse in der x-y- Ebene;
FIG. 9 eine Querschnittsansicht eines oberflächenmontierbaren Gehäuses mit elektrischen Kontakten;
Fig. 10a ein Photovoltaikbauteil für einen vorwiegend horizontalen Einbau in eine Vorrichtung;
Fig. 10b ein Photovoltaikbauteil mit einer schrägen Einbaulage;
Fig. 10c ein Photovoltaikbauteil für einen vorwiegend vertikalen Einbau in eine Vorrichtung;
FIG. 11 eine Draufsicht auf ein Photovoltaik-Chip Array;
FIG. 12 ein Linsenarray gemäss einer Ausführungsform der Erfindung mit einer Vielzahl von in einer Ebene angeordneten Kondensorlinsen;
FIG. 13 ein Array mit einer Vielzahl flächig in einer Ebene angeordneten Umlenkoptiken;
FIG. 14 zeigt eine Seitenansicht eines Gebäudes bzw. Hauses mit Photovoltaikbauteilen;
FIG. 15 zeigt eine Draufsicht des Gebäudes der FIG. 14;
FIG. 16 zeigt eine Seitenansicht eines Hauses mit einem flachen Dach;
Fig. 17 eine Querschnittsansicht eines energieerzeugenden Photovoltaikbauteils;
Fig. 18 eine Querschnittsansicht eines energieerzeugenden Photovoltaikbauteils;
Fig. 19 ein Flugzeug mit mehreren in die Aussenhaut des Flugzeugs integrierten Photovoltaikbauteilen;
Fig. 20 ein Schiff mit mehreren auf der Oberfläche des Schiffes angeordneten Photovoltaikbauteilen;
FIG. 21 ein Photovoltaikbauteil welches oberhalb einer Agrarfläche angeordnet ist;
Fig. 22 ein Automobil mit integrierten Photovoltaikbauteilen;
FIG. 23 ein Gewächshaus mit integrierten Photovoltaikbauteilen gemäss Ausführungsformen der Erfindung;
FIG. 24a zeigt eine Querschnittsansicht eines energieerzeugenden Photovoltaikbauteils gemäss einer weiteren Ausführungsform der Erfindung; und
FIG. 24b zeigt eine vergrösserte Darstellung eines Konzentrator-Photovoltaik-Moduls mit Prismen als Umlenkoptik.

### Weg(e) zur Ausführung der Erfindung

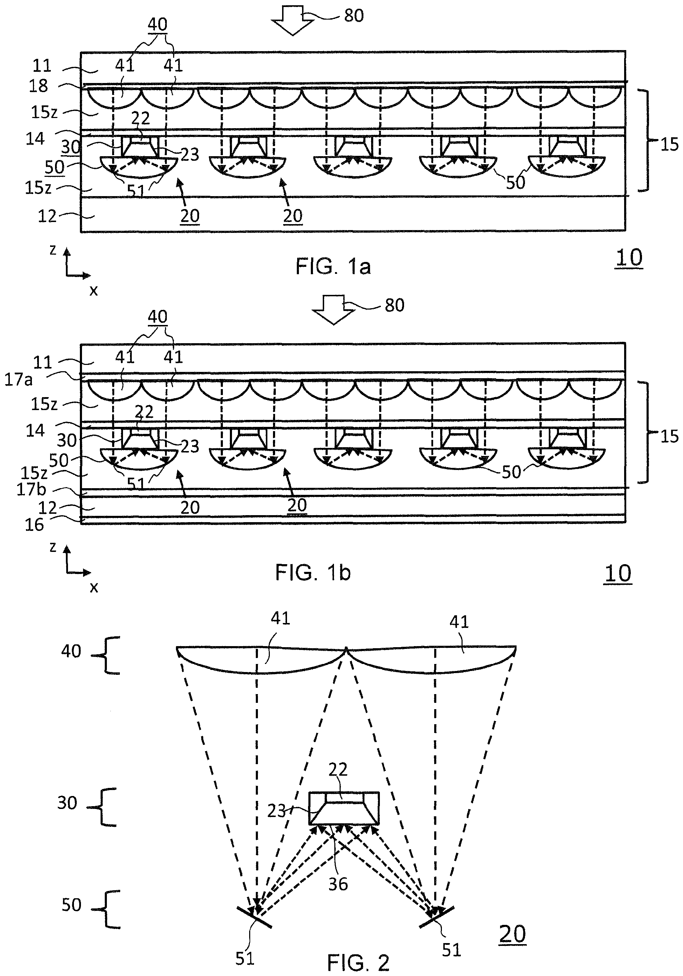

FIG. 1a zeigt eine Querschnittsansicht eines energieerzeugenden Photovoltaikbauteils 10 in einer x-z-Ebene gemäss einer Ausführungsform der Erfindung. Das energieerzeugende Photovoltaikbauteil 10 weist eine äussere Scheibe 11 und eine innere Scheibe 12 auf. Die äussere Scheibe 11 und die innere Scheibe 12 können gemäss Ausführungsformen aus Glas oder aus Kunststoff bestehen. Die äussere Scheibe 11 hat gemäss Ausführungsformen eine hohe Transmission im gewünschten Wellenlängenbereich und kann insbesondere als Klarglasscheibe oder als nicht gefärbte Kunststoffscheibe ausgeführt sein. Die innere Scheibe 12 kann gemäss Ausführungsformen ebenfalls mit hoher Transmission ausgeführt sein und als Klarglasscheibe oder als nicht gefärbte Kunststoffscheibe ausgeführt sein.

Gemäss Ausführungsformen der Erfindung weist die äussere Scheibe einen Transmissionsgrad von mehr als 80%, insbesondere von mehr als 90% auf. Dabei bezieht sich der Transmissionsgrad insbesondere auf den für das menschliche Auge sichtbaren Spektralbereich, d.h. insbesondere auf Licht mit einer Wellenlänge zwischen 380 und 780 Nanometern (nm). Der Transmissionsgrad kann auch als Lichtdurchlässigkeit bezeichnet werden.

Gemäss Ausführungsformen der Erfindung können die äussere Scheibe 11 und die innere Scheibe 12 aus Glas, wie z.B. Kalk-Natron-Silicatglas, Borosilicatglas, Alumosilicatglas oder aus Kunststoff, wie z.B. aus Polycarbonat oder PMMA, bestehen. Gemäss Ausführungsformen der Erfindung können die äussere Scheibe 11 und die innere Scheibe 12 verschiedene Dicken aufweisen, und die äussere Glasscheibe 11 und die innere Glasscheibe 12 können mit oder ohne thermische oder chemische Vorspannung ausgeführt sein. Gemäss einer Ausführungsform können sowohl die erste Scheibe als auch die zweite Scheibe aus Glas bestehen. Gemäss einer anderen Ausführungsform kann die erste Scheibe aus Glas und die zweite Scheibe aus Kunststoff bestehen. Gemäss einer anderen Ausführungsform kann die zweite Scheibe aus Glas und die erste Scheibe aus Kunststoff bestehen. Gemäss einer Ausführungsform können sowohl die erste Scheibe als auch die zweite Scheibe aus Kunststoff bestehen.

Zwischen der äusseren Scheibe 11 und der inneren Scheibe 12 ist eine energieerzeugende Schicht 15 vorgesehen. Die energieerzeugende Schicht 15 weist eine Mehrzahl von Konzentrator-Photovoltaikmodulen 20 auf. Die Konzentrator-Photovoltaik-Module 20 weisen eine Kondensoroptik 40 als primäre Optik auf. Die Kondensoroptiken 40 der Konzentrator-Photovoltaik-Module 20 weisen jeweils eine oder mehrere Kondensorlinsen 41 auf, welche seitlich versetzt zueinander, d.h. in der x-Richtung und/oder der y-Richtung versetzt zueinander angeordnet sind. In diesem Ausführungsbeispiel sind die Kondensorlinsen 41 in der vertikalen z-Richtung auf gleicher Höhe angeordnet. Gemäss anderen Ausführungsformen der Erfindung ist es jedoch auch möglich, dass die Kondensorlinsen 41 auch vertikal, d.h. in der z-Richtung versetzt zueinander angeordnet sind.

Die Kondensorlinsen 41 sammeln bzw. bündeln das durch die äussere Scheibe 11 einfallende Licht und sie können daher auch als Sammellinsen bezeichnet werden. Die Kondensorlinsen 41 können gemäss Ausführungsformen bi-konvex, plan-konvex oder konkav-konvex ausgestaltet sein.

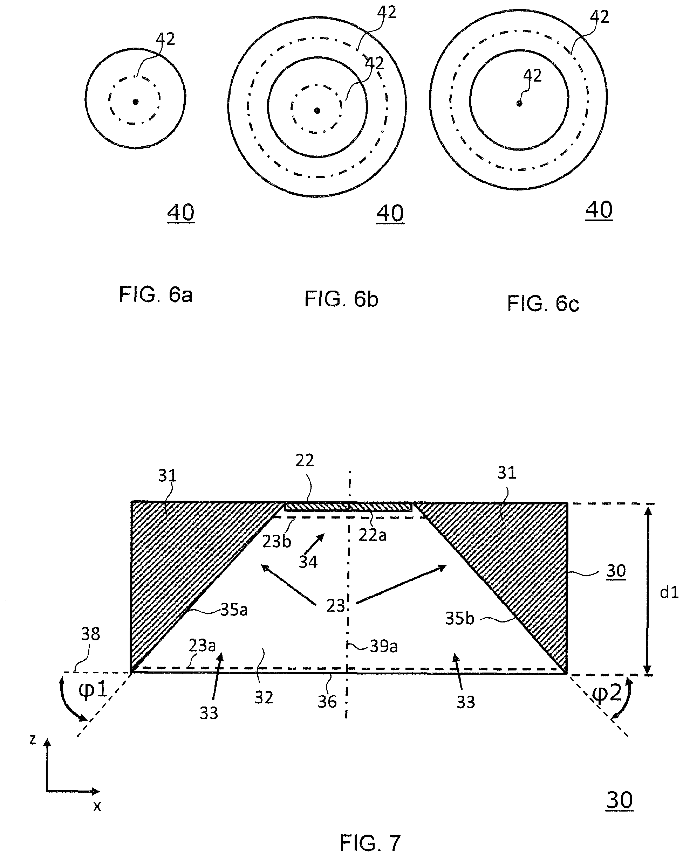

Die Konzentrator-Photovoltaik-Module 20 weisen zudem eine teiltransparente Umlenkoptik 50 als sekundäre Optik auf und einen Photovoltaik-Chip 22, der in ein oberflächenmontierbares Gehäuse 30 integriert ist, auf. Das oberflächenmontierbare Gehäuse 30 weist eine transparente Abdeckung 36 (siehe FIG. 7) und einen integrierten Reflektor 23 als tertiäre Optik auf. Die Kondensoroptik 40 ist in vertikaler Richtung, d.h. in der z-Richtung, zwischen der äusseren Scheibe 11 und dem Photovoltaik-Chip 22 angeordnet. Die teiltransparente Umlenkoptik 40 ist in vertikaler Richtung, d.h. in der z-Richtung, zwischen dem Photovoltaik-Chip 22 und der inneren Scheibe 12 angeordnet.

Die transparente Abdeckung 36 und eine unter der transparenten Abdeckung angeordnete Eintrittsöffnung 23a (siehe FIG. 7) des integrierten Reflektors 23 sind der inneren Scheibe 12 zugewandt. Mit anderen Worten, der Photovoltaik-Chip 22 ist nach unten angeordnet bzw. die optische Öffnung des oberflächenmontierbaren Gehäuses 30 und des Photovoltaik-Chips 22 ist nach unten in Richtung auf die innere Glasscheibe 11 gerichtet.

Im Solarbetrieb ist die Kondensoroptik dazu konfiguriert, durch die äussere Scheibe 11 einfallendes Sonnenlicht 80 auf die Umlenkoptik 50 zu fokussieren, insbesondere auf Umlenkbereiche 51 der Umlenkoptik 50. In diesem Ausführungsbeispiel haben die Kondensorlinsen 41 eine konzentrische Mittelebene und fokussieren das einfallende Licht auf ringförmige Umlenkbereiche 51 der Umlenkoptik 50. Die Umlenkbereiche 51 sind seitlich versetzt zu dem Gehäuse 30 angeordnet und die Kondensoroptik 40 leitet das einfallende Licht seitlich an dem Gehäuse 30 vorbei auf die Umlenkbereiche 51.

Die Umlenkbereiche 51 der Umlenkoptik 50 können insbesondere als reflektierende bzw. spiegelnde Flächen ausgestaltet sein. Die Umlenkoptik 50 lenkt das von der Kondensoroptik 40 auf die Umlenkbereiche 51 fokussierte Sonnenlicht in den integrierten Reflektor 23 um. Der entsprechende Strahlenverlauf des einfallenden Lichts ist in der FIG. 1 gestrichelt dargestellt. Hierbei ist zu beachten, dass die Darstellung des Strahlenverlaufs grob schematisch ist, um das Prinzip darzustellen.

Der integrierte Reflektor 23 konzentriert bzw. sammelt das von der Umlenkoptik 50 umgelenkte Sonnenlicht auf den Photovoltaik-Chip 22.

Die energieerzeugende Schicht 15 umfasst eine Kontaktierungsschicht 14 mit Leiterbahnen. Die Kontaktierungsschicht 14 kann beispielsweise als Leiterplatte, insbesondere als flexible Leiterplatte und insbesondere als flexible sowie transparente Folie ausgebildet sein. Die Kontaktierungsfolie 14 kann als wärmeableitende Folie ausgebildet sein.

Die oberflächenmontierbaren Gehäuse 30 können mittels Löten, insbesondere mittels Reflow-Löten, auf der Kontaktierungsschicht 14 angeordnet werden und elektrisch mit den Photovoltaik Chips 22 verbunden werden.

Gemäss Ausgestaltungen der Erfindung kann die energieerzeugende Schicht 15 bzw. die Zwischenräume 15z der energieerzeugenden Schicht 15 mit transparentem Kunststoff aufgefüllt sein. Gemäss anderen Ausgestaltungen der Erfindung kann die energieerzeugende Schicht 15 bzw. die Zwischenräume 15z der energieerzeugenden Schicht 15 als Vakuum ausgebildet sein.

Zwischen der äusseren Scheibe 11 und der energieerzeugenden Schicht 15 ist eine Schutzschicht 18 zum Schutz gegen ultraviolette (UV)Strahlung vorgesehen. Diese Schutzschicht schützt insbesondere die Elemente der energieerzeugenden Schicht, z.B. das oberflächenmontierbare Gehäuse 30, die Kontaktierungsschicht 14, die Kondensoroptik 40 und die Umlenkoptik 50 vor der UV-Strahlung. Dies ist insbesondere bei Ausführungsformen, vorteilhaft, bei denen die Elemente der energieerzeugenden Schicht 15 aus Kunststoff bestehen bzw. Kunststoff aufweisen. Die UV-Schutzschicht 18 schützt den Kunststoff vor Alterung.

Die Schutzschicht 18 kann gemäss einer Ausführungsform als Folie ausgebildet sein. Gemäss einer anderen Ausführungsform kann eine Beschichtung der äusseren Scheibe 11 als UV-Schutzschicht vorgesehen sein.

FIG. 1b zeigt eine Querschnittsansicht eines energieerzeugenden Photovoltaikbauteils 10 in einer x-z-Ebene gemäss einer weiteren Ausführungsform der Erfindung. Das Photovoltaikbauteil 10 entspricht zu grossen Teilen dem Photovoltaikbauteil 10 von FIG. 1a.

Gemäss der Ausgestaltung von FIG. 1b ist die energieerzeugende Schicht 15 mittels einer äusseren Verbundschicht 17a und einer inneren Verbundschicht 17b zwischen der äusseren Scheibe 11 und der inneren Scheibe 12 integriert. Die Verbundschichten 17a, 17b können insbesondere als Laminationsfolien ausgebildet sein und aus Kunststoff bestehen, z.B. aus PVB oder EVA. Derartige Verbundschichten erleichtern die Fertigung des energieerzeugenden Photovoltaikbauteils.

Gemäss einer weiteren Ausgestaltung der Erfindung können die Photovoltaikbauteile 10 auch weitere Schichten, insbesondere Folien aufweisen. So können gemäss Ausgestaltungen der Erfindung hinter bzw. unter der energieerzeugenden Schicht 15 eine wärmeabsorbierende Folie oder eine wärmeableitende Folie angeordnet werden.

Gemäss Ausgestaltungen können die Folien transparent oder teiltransparent ausgebildet sein und als Laminationsfolie appliziert werden. Gemäss Ausgestaltungen können die Photovoltaikbauteile 10 mit einer Kratzschutzbeschichtung im Falle von Kunststoff und/oder einer low-E-Beschichtung im Falle von Glas versehen sein, was in der FIG. 1b exemplarisch als Schicht 16 gezeigt ist.

FIG. 2 zeigt eine vergrösserte Darstellung eines Konzentrator-Photovoltaik-Moduls 20 gemäss einer Ausführungsform der Erfindung mit einem exemplarischen Strahlengang. Die Kondensorlinsen 41 der Kondensoroptik 40 fokussieren das einfallende Licht auf die Umlenkbereiche 51 der Umlenkvorrichtung 50. Dann wird das einfallende Licht von den Umlenkbereichen 51 in Richtung auf das oberflächenmontierbare Gehäuse 30, insbesondere auf deren transparente Abdeckung, reflektiert und von dem integrierten Reflektor 23 auf den Photovoltaik-Chip 22 geleitet. Dabei ist gemäss den Beispielen der Figuren 1a, 1b und 2 eine einstufige Umlenkung dargestellt.

Gemäss anderen Ausführungsformen kann aber auch eine mehrstufige Umlenkung durch die Umlenkvorrichtung 50 erfolgen.

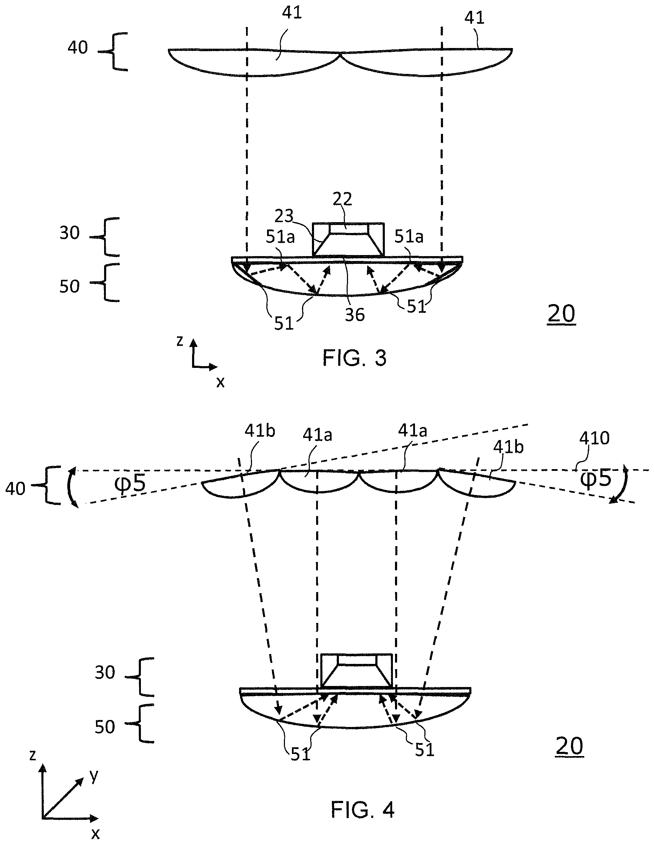

So zeigt die FIG. 3 eine vergrösserte Darstellung eines Konzentrator-Photovoltaik-Moduls 20 gemäss einer Ausführungsform der Erfindung mit einer mehrstufigen Umlenkung bzw. Reflexion. Hierzu weist die Umlenkvorrichtung 50 mehrere Umlenk- bzw. Reflexionsbereiche 51 auf.

Die Umlenkung der Umlenkvorrichtung 50 kann gemäss Ausführungsformen auf verschiedenste Weise erfolgen. Neben dem Vorsehen von reflektierenden bzw. spiegelnden Flächen, z.B. von reflektierenden Beschichtungen oder Spiegeln kann die Umlenkvorrichtung gemäss Ausführungsformen auch als Lichtwellenleiter ausgebildet sein oder einen Lichtwellenleiter aufweisen. Insbesondere können auch Mischformen vorgesehen sein. So können gemäss Ausführungsformen Reflexionsbereiche vorgesehen sein, welche das fokussierte Licht von der Kondensoroptik 40 empfangen und dann in einen Lichtwellenleiter reflektieren bzw. einkoppeln, der das Licht an den Reflektor des Gehäuses 30 weiterleitet.

Die Umlenkvorrichtung 50 kann gemäss Ausführungsformen aus einem Grundkörper aus transparentem Kunststoff oder Glas bestehen. In einem derartigen Grundkörper aus Glas oder Kunststoff sind dann gemäss Ausführungsformen die reflektierenden Umlenkbereiche 51 integriert, z.B. mittels reflektierender Beschichtungen. Gemäss Ausführungsformen kann an den Grenzflächen der Umlenkvorrichtung gemäss Ausführungsformen auch der Effekt der Totalreflexion ausgenutzt werden. Dies ist in der FIG. 3 insbesondere an den oberen Umlenkbereichen 51a möglich, auf welche das Licht in einem flachen Winkel auftrifft. Gemäss Ausführungsformen kann der Effekt der Totalreflexion durch Beschichtungen der Oberfläche der Umlenkvorrichtung 50 implementiert werden, beispielsweise durch das Vorsehen von Beschichtungen mit einem geringem Brechungsindex.

FIG. 4 zeigt ein Konzentrator-Photovoltaik-Modul 20 mit mehreren Kondensorlinsen, namentlich zwei Kondensorlinsen 41a, 41b, welche nebeneinander angeordnet sind. Dabei ist die äussere Kondensorlinse 41b in einem Winkel ϕ5, welcher nachfolgend auch als fünfter Winkel bezeichnet werden kann, gegenüber der horizontalen x-y-Ebene 410 des Photovoltaikbauteils 10 bzw. des Konzentrator-Photovoltaik-Moduls 20 geneigt angeordnet. Die innere Linse 41a ist parallel zu der horizontalen Ebene 410 des Photovoltaikbauteils 10 bzw. des Konzentrator-Photovoltaik-Moduls 20 angeordnet.

Es ist hierbei zu beachten, dass der Begriff horizontale Ebene des Photovoltaikbauteils 10 bzw. des Konzentrator-Photovoltaik-Moduls sich auf die Grundfläche bzw. Bodenfläche des Photovoltaikbauteils bzw. des Konzentrator-Photovoltaik-Moduls bezieht und insbesondere parallel zu der Grundfläche und damit parallel zu der inneren Scheibe 12 und der äusseren Scheibe 11 verlaufen soll. Durch die geneigte Anordnung der äusseren Kondensorlinsen 41b ist es möglich, das Sonnenlicht auch bei geringer Elevation, z.B. am Morgen und am Abend, in verbesserter Weise zu nutzen.

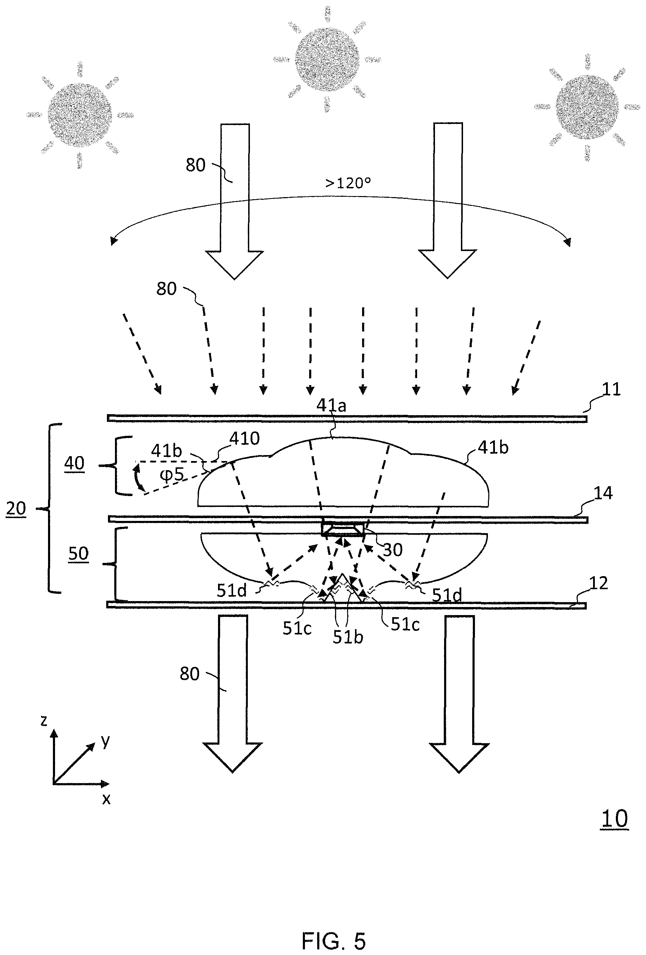

FIG. 5 zeigt eine Querschnittsansicht eines energieerzeugenden Photovoltaikbauteils 10 in einer x-z-Ebene gemäss einer Ausführungsform der Erfindung. Das energieerzeugende Photovoltaikbauteil 10 weist eine äussere Scheibe 11 und eine innere Scheibe 12 auf. Die äussere Scheibe 11 und die innere Scheibe 12 können gemäss Ausführungsformen aus Glas oder aus Kunststoff bestehen.

Zwischen der äusseren Scheibe 11 und der inneren Scheibe 12 sind eine Mehrzahl von Konzentrator-Photovoltaikmodulen 20 angeordnet, wobei in der FIG. 5 nur ein Konzentrator-Photovoltaikmodul 20 aus Gründen der besseren Darstellbarkeit gezeigt ist. Die Konzentrator-Photovoltaik-Module 20 weisen eine Kondensoroptik 40 als primäre Optik auf. Die Kondensoroptiken 40 der Konzentrator-Photovoltaik-Module 20 weisen eine innere Linse 41a auf, welche zentral über dem Gehäuse 30 angeordnet ist. Daneben ist eine äussere Linse 41b angeordnet, welche die innere Linse 41a konzentrisch umschliesst.

Dabei ist die äussere Kondensorlinse 41b in einem Winkel ϕ5 gegenüber der horizontalen x-y-Ebene des Photovoltaikbauteils 10 (und damit auch gegenüber den Scheiben 11, 12) geneigt angeordnet. Die innere Linse 41a ist parallel zu der horizontalen Ebene 410 des Photovoltaikbauteils 10 bzw. des Konzentrator-Photovoltaik-Moduls 20 angeordnet. Damit kann gemäss Ausführungsformen das einfallende Sonnenlicht in einem Bereich von mehr als 120° eingefangen werden.

Die Konzentrator-Photovoltaik-Module 20 weisen zudem eine teiltransparente Umlenkoptik 50 als sekundäre Optik und einen Photovoltaik-Chip 22, der in ein oberflächenmontierbares Gehäuse 30 integriert ist, auf.

Im Solarbetrieb ist die Kondensoroptik 40 dazu konfiguriert, durch die äussere Scheibe 11 einfallendes Sonnenlicht 80 auf die Umlenkoptik 50 zu fokussieren. Gemäss diesem Ausführungsbeispiel fokussiert die innere Linse 41a das Licht auf zentrale Umlenkbereiche 51b.Von diesen wird es auf Umlenkbereiche 51c reflektiert und von dort in Richtung auf das Gehäuse 30 und den Reflektor 23. Die äussere Linse 41b fokussiert das Licht auf äussere Umlenkbereiche 51d. Von diesen wird das Licht in Richtung auf das Gehäuse 30 und den Reflektor 23 reflektiert. Die Umlenkbereiche 51b, 51c und 51d sind in der FIG. 5 als wellenförmiges Muster dargestellt und sie können insbesondere als reflektierende bzw. spiegelnde Flächen ausgestaltet sein. Der entsprechende Strahlenverlauf des einfallenden Lichts ist in der FIG. 5 erneut gestrichelt grob schematisch dargestellt.

Gemäss Ausführungsformen decken die Umlenkbereiche 51, in diesem Beispiel die Umlenkbereiche 51b, 51c und 51d maximal 20%, insbesondere maximal 15%, der horizontalen Querschnittsfläche (in der x-y-Ebene) des Photovoltaik-Bauteils 10 ab. Dadurch ist es gemäss Ausführungsformen der Erfindung möglich, eine Lichtdurchlässigkeit bzw. Transparenz des Photovoltaikbauteils von mehr als 50% und bevorzugt von mehr als 75% zu erreichen, insbesondere bezogen auf den für den Mensch sichtbaren Spektralbereich des Sonnenlichts.

FIG. 6a zeigt eine Draufsicht auf eine Kondensoroptik 40, welche gemäss den Figuren 1a, 1b, 2 und 3 ausgestaltet ist. Dabei deutet die strichpunktierten Linie 42 die Mittelebene der Linsen an.

FIG. 6b zeigt eine Draufsicht auf eine Kondensoroptik 40, welche gemäss der Figur 4 ausgestaltet ist. Dabei deuten die strichpunktierten Linien 42 die Mittelebenen der Linsen an.

FIG. 6c zeigt eine Draufsicht auf eine Kondensoroptik 40, welche gemäss der Figur 5 ausgestaltet ist. Dabei deutet die strichpunktierte Linie 42 sowie der Punkt 42 die Mittelebene der Linsen an.

FIG. 7 zeigt eine Querschnittsansicht des oberflächenmontierbaren Gehäuses 30 in einer x-z-Ebene gemäss einer Ausführungsform der Erfindung. Gemäss dieser Ausführungsform ist der Photovoltaik-Chip 22 symmetrisch in Bezug auf eine vertikale Symmetrieebene 39a des Gehäuses 30 angeordnet.

Das Gehäuse 30 umfasst einen Basiskörper 31. Der Basiskörper 31 kann insbesondere aus Kunststoff bestehen und beispielsweise mittels eines Spritzgussverfahrens hergestellt werden. Das Gehäuse 30 bzw. der Basiskörper 31 weist eine Aussparung 32 auf. Die Aussparung 32 formt bzw. bildet eine Aufnahmewanne 33 mit einem vertieften Bodenabschnitt 34 zur Aufnahme des Photovoltaik-Chips 22. Der Photovoltaik-Chip 22 ist gemäss bevorzugten Ausgestaltungen der Erfindung als Multi-Junction Solarzelle ausgebildet, kann aber gemäss anderen Ausführungsformen der Erfindung auch als Single-Junction Solarzelle ausgebildet sein. Unter einem Photovoltaik-Chip wird gemäss Ausführungsformen der Erfindung insbesondere ein photovoltaischer DIE, d.h. ein ungehäustes Stück eines Halbleiter-Wafers mit einer Multi-Junction oder Single-Junction Solarzelle verstanden.

Das Gehäuse 30 weist wenigstens zwei elektrische Kontakte zur Kontaktierung des Photovoltaik-Chips 22 auf, welche in der FIG. 7 zur Vereinfachung der Illustration nicht dargestellt sind. Das Gehäuse 30 weist ferner eine transparente Abdeckung 36 auf, welche das Gehäuse 30 und insbesondere die Aussparung 32 verschliesst, insbesondere wasserdicht und staubdicht verschliesst.

Die transparente Abdeckung 36 besteht gemäss Ausführungsformen aus Glas, insbesondere aus Dünnglas oder ultradünnem Glas. Vorzugsweise ist das Gehäuse 30 mittels der transparenten Abdeckung 36 gegen feste Fremdkörper und gegen Flüssigkeiten geschützt. Hierzu kann das Gehäuse 36 insbesondere gemäss der IP Schutzklasse 66 ausgebildet sein. Gemäss Ausführungsformen weist Gehäuse 36 einen Schutzumfang gemäss dem International Protection (IP-Code) gegen feste Fremdkörper von wenigstens 4 und einen Schutzumfang gegen Flüssigkeiten von wenigstens 4 auf. Die transparente Abdeckung 36 kann beispielsweise mittels Ultraschallschweissen an dem Gehäuse 30, insbesondere an dem Basiskörper 31, befestigt werden.

Die Aufnahmewanne 33 weist Seitenwände mit reflektierenden Bereichen 35a und 35b auf. Die Aufnahmewanne 33 bildet mittels der reflektierenden Bereiche einen Reflektor 23. Der Reflektor 23 stellt eine tertiäre Optik des Konzentrator-Photovoltaikmoduls 20 dar und ist dazu konfiguriert, als Lichtsammler bzw. optischer Homogenisierer zu funktionieren. Der Reflektor 23 kann gemäss Ausführungsformen als konischer Zylinder oder als konischer Quader ausgeführt sein. Der Reflektor 23 weist unter der transparenten Abdeckung 36 eine Eintrittsöffnung bzw. Eintrittsapertur 23a auf. Ferner weist der Reflektor 23 eine Austrittsöffnung bzw. Austrittsapertur 23b auf, durch welche das Licht auf den Photovoltaik-Chip 22 fällt. Die Eintrittsöffnung 23a und die Austrittsöffnung 23b sind schematisch durch gestrichelte Linien dargestellt.

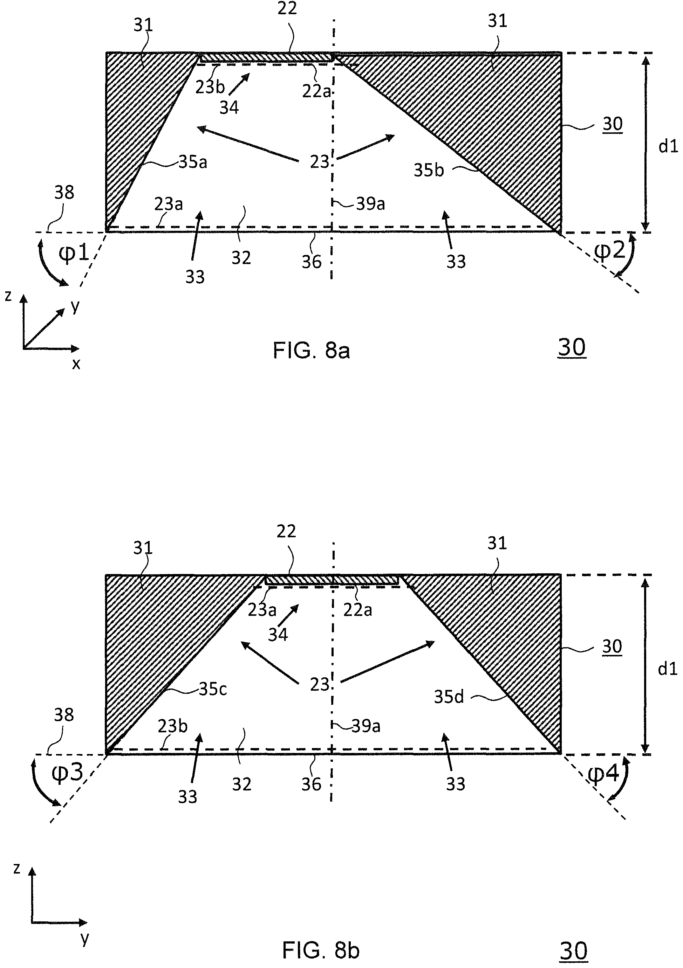

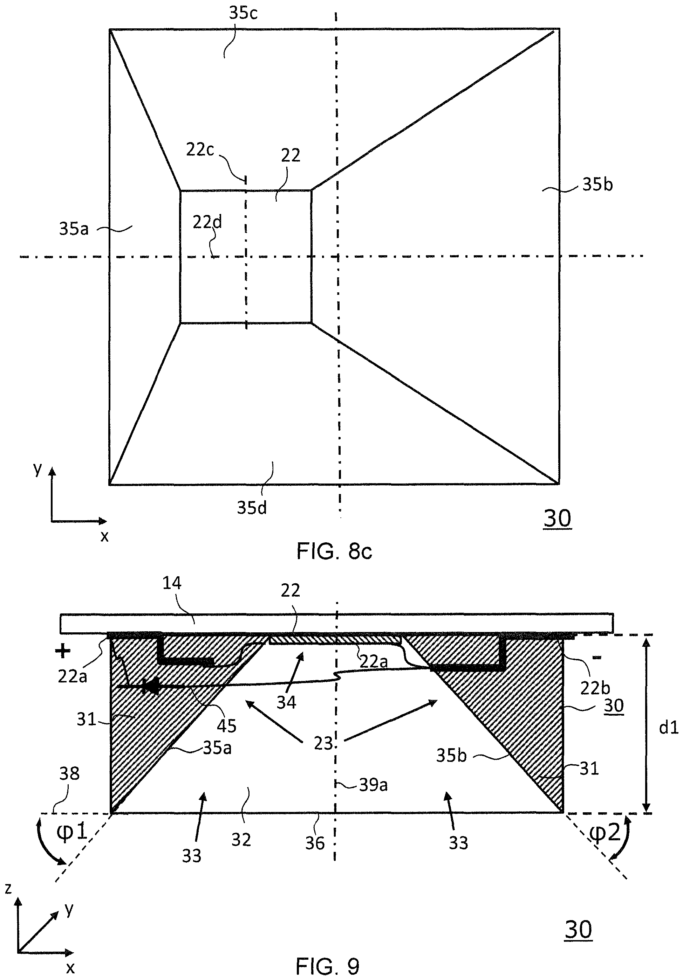

FIG. 8a zeigt eine Querschnittsansicht eines oberflächenmontierbaren Gehäuses 30 in einer x-z- Ebene gemäss einer weiteren Ausführungsform der Erfindung. FIG. 8b zeigt eine Querschnittsansicht des oberflächenmontierbaren Gehäuses 30 in einer y-z-Ebene, die senkrecht zu der x-z-Ebene verläuft. FIG. 8c zeigt eine Draufsicht auf das oberflächenmontierbare Gehäuses in der x-y-Ebene.

Das oberflächenmontierbare Gehäuses 30 ist ähnlich zu dem in der FIG. 7 dargestellten Gehäuse 30 aufgebaut und weist dementsprechend einen Basiskörper 31 und eine Aussparung 32 auf, die eine Aufnahmewanne 33 mit einem vertieften Bodenabschnitt 34 zur Aufnahme des Photovoltaik-Chips 22 bildet.

Die Aufnahmewanne 33 weist Seitenwände mit einem ersten reflektierenden Bereich 35a, einem zweiten reflektierendem Bereich 35b, einem dritten reflektierenden Bereich 35c und einem vierten reflektierendem Bereich 35d auf. Der erste reflektierende Bereich 35a ist in einem ersten Winkel ϕ1 gegenüber einer horizontalen x-y-Ebene 38 des Gehäuses 30 ausgerichtet ist. Der zweite reflektierende Bereich 35b ist in einem zweiten Winkel ϕ2 gegenüber der horizontalen x-y-Ebene 38 des Gehäuses 30 ausgerichtet ist. Der dritte reflektierende Bereich 35c ist in einem dritten Winkel ϕ3 gegenüber der horizontalen x-y-Ebene 38 des Gehäuses 10 ausgerichtet ist. Der vierte reflektierende Bereich 35d ist in einem vierten Winkel ϕ4 gegenüber der horizontalen x-y-Ebene 38 des Gehäuses ausgerichtet ist. Gemäss der in den Figuren 8a bis 8c dargestellten Ausführungsform ist der erste Winkel ϕ1 unterschiedlich zu dem zweiten Winkel ϕ2, während der dritte Winkel ϕ3 und der vierte Winkel ϕ4 in diesem Beispiel gleich gross bzw. in etwa gleich gross sind. Gemäss anderen Ausführungsformen können auch der dritte Winkel ϕ3 und der vierte Winkel ϕ4 unterschiedlich gross sein.

Wie insbesondere aus den Figuren 8a und 8b ersichtlich, ist der Photovoltaik-Chip 22 in Bezug auf die vertikale Symmetrieebene 39a des Gehäuses 30 asymmetrisch angeordnet, während er in Bezug auf die vertikale Symmetrieebene 39b des Gehäuses 30 symmetrisch angeordnet ist.

Wie insbesondere aus den Figuren 8a und 8c ersichtlich ist, liegen sich der erste reflektierende Bereich 35a und der zweite reflektierende Bereich 35b in Bezug auf den Photovoltaik-Chip 22 gegenüber, insbesondere in Bezug auf eine in der FIG. 8c gezeigte erste vertikale Symmetrieebene 22c des Photovoltaik-Chips 22.

Gemäss dem gezeigten Beispiel beträgt der erste Winkel ϕ1 ungefähr 65° und der zweite Winkel ϕ2 ungefähr 35°.

Gemäss Ausführungsformen der Erfindung liegen die Winkel ϕ1, ϕ2, ϕ3 und ϕ4 in einem Bereich zwischen 0° und 110°. Gemäss bevorzugten Ausgestaltungen der Erfindung liegt der erste Winkel ϕ1 in einem Bereich zwischen 45° und 110°, insbesondere in einem Bereich zwischen 60° und 90° und ist somit relativ steil, während der zweite Winkel ϕ2 in einem Bereich zwischen 0° und 45°, insbesondere in einem Bereich zwischen 10° und 35°, liegt, und somit relativ flach ist.

Eine derartige Ausgestaltung ist z.B. für Photovoltaik-Module vorteilhaft, welche für einen senkrechten Einbau bestimmt sind. Damit wird es ermöglicht, die Leistungsausbeute des Photovoltaik-Moduls bei vertikalem Einbau deutlich zu verbessen, indem insbesondere die "untere" reflektierende Fläche stärker in Bezug auf die horizontale Ebene des Gehäuses geneigt ist als die "obere" reflektierende Fläche.

Gemäss Ausführungsformen sind der erste reflektierende Bereich 35a, der zweite reflektierende Bereich 35b, der dritte reflektierende Bereich 35c und der vierte reflektierende Bereich 35d als Beschichtung auf dem Basiskörper 31 der Aufnahmewanne 33 aufgebracht.

Gemäss anderen Ausführungsformen sind der erste reflektierende Bereich 35a, der zweite reflektierende Bereich 35b, der dritte reflektierende Bereich 35c und der vierte reflektierende Bereich 35d als reflektierende Folie ausgebildet, welche z.B. mittels Kleben oder anderen Verfahren auf den Basiskörper 31 der Aufnahmewanne 33 aufgebracht werden kann.

Gemäss den in den Figuren 8a bis 8c gezeigten Ausführungsformen sind die reflektierenden Bereiche 35a, 35b, 35c und 35d jeweils als plane Flächen ausgebildet, insbesondere als trapezförmige Flächen.

Gemäss anderen nicht dargestellten Ausführungsformen können die reflektierenden Bereiche 35a, 35b, 35c und 35d jedoch auch andere Formen aufweisen, insbesondere konkave Formen und konvexe Formen.

Ein derart ausgestaltetes Modul ermöglicht es, die Winkel ϕ1, ϕ2, ϕ3 und ϕ4 der reflektierenden Bereiche 35a 35b, 35c und 35d jeweils individuell und unterschiedlich zu wählen und an die jeweilige Ausrichtung der Module an die zum Einbau vorgesehenen Flächen und die damit korrespondierende Sonnenexposition der Module im Hinblick auf die Elevation und/oder den Azimut zu berücksichtigen.

FIG. 9 zeigt eine Querschnittsansicht eines eines oberflächenmontierbaren Gehäuses 30 in einer x-z-Ebene gemäss einer Ausführungsform der Erfindung. In der FIG. 9 sind die elektrischen Anschlüsse des Moduls näher dargestellt. Insbesondere weist das oberflächenmontierbaren Gehäuses 30 einen ersten elektrischen Kontakt 22a und einen zweiten elektrischen Kontakt 22b auf. Die elektrischen Kontakte 22a, 22b sind auf gegenüberliegenden Seiten des Gehäuses 30 angeordnet und als sogenannte Leads ausgebildet, welche in dem Basiskörper 31 aus Kunststoff eingebettet sind. Der Photovoltaik-Chip 22 ist mittels Wire-Bonding mit den Leads der elektrischen Kontakte 22a und 22b elektrisch verbunden. Somit ist das Modul 20 als oberflächenmontierbares Modul in SMD-Technik (Surface Mount Technology) ausgebildet. Das Modul 20 weist zudem eine in das Gehäuse 30 integrierte Bypass-Diode 45 auf, welche insbesondere als Schottky-Diode ausgeführt sein kann. Die Bypass-Diode ist parallel zu dem Photovoltaik-Chip 22 geschaltet und dementsprechend einerseits mit dem elektrischen Kontakt 22a und andererseits mit dem elektrischen Kontakt 22b verbunden, ebenfalls gemäss Ausführungsformen mittels Wire-Bonding. Der Photovoltaik-Chip 22 kann beispielsweise mit Leiterbahnen der Kontaktierungsschicht 14 mittels Löten elektrisch kontaktiert werden.

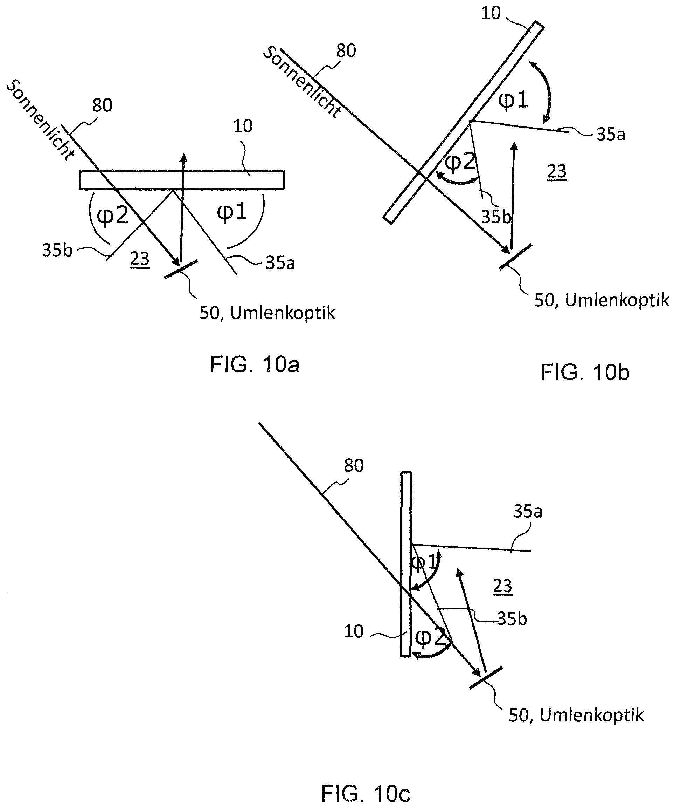

Die Figuren 10a bis 10c zeigen verschiedene Einbausituationen von Photovoltaikbauteilen 10 und den darin integrierten oberflächenmontierbaren Gehäusen. Die Winkel ϕ1 und ϕ2 beziehen sich auf die Winkel der Reflexionsflächen 35a, 35b der in die Gehäuse 30 integrierten Reflektoren 23.

In den Figuren 10a bis 10c ist der Sonnenstand 80 in exemplarischer Weise dargestellt, z.B. zu der Mittagszeit.

Zudem sind in den Figuren 10a bis 10c der Verlauf der Reflexionsflächen 35a, 35b der Reflektoren 23 in exemplarischer schematischer Weise mittels einfacher Linien dargestellt. Zudem ist exemplarisch die Umlenkoptik 50 gezeigt, welche das einfallende Sonnenlicht 80 in den Reflektor 23 reflektiert.

Fig. 10a zeigt ein Photovoltaikbauteil 10, das für einen vorwiegend horizontalen Einbau in ein Gebäude oder ein Vorrichtung vorgesehen ist, z.B. als horizontales Dach-Photovoltaikbauteil. Fig. 10b zeigt eine Photovoltaikbauteil 10, welches für schräge Einbaulagen, beispielsweise zwischen 20° und 80°, vorgesehen ist, z.B. für Schrägdächer.

Fig. 10c zeigt ein Photovoltaikbauteil 10, das für einen vorwiegend vertikalen Einbau in ein Gebäude oder eine Vorrichtung vorgesehen ist.

Der erste Winkel ϕ1 und der zweite Winkel ϕ2 können gemäss Ausgestaltungen der Erfindung jeweils individuell an die jeweilige Einbausituation angepasst werden, um den Lichteinfang des Reflektors 23 für die jeweilige Einbausituation zu optimieren. Während bei einem horizontalen Einbau der erste Winkel ϕ1 und der zweite Winkel ϕ2 vorzugsweise gleich gross gewählt werden, sind bei einer schrägen und einer vertikalen Einbausituation der erste Winkel ϕ1 und der zweite Winkel ϕ2 vorzugsweise unterschiedlich gewählt, um den Lichteinfang in Bezug auf die Elevation der Sonnenstrahlung zu erhöhen.

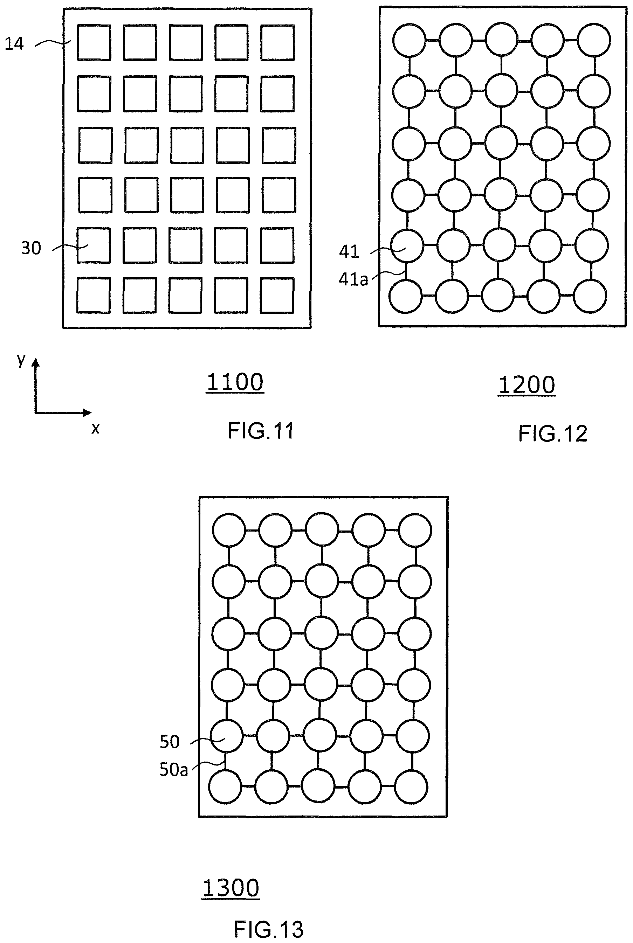

FIG. 11 zeigt eine Draufsicht auf ein Photovoltaik-Chip Array 1100. Das Photovoltaik-Chip Array 1100 weist eine Vielzahl von SMD- Gehäusen 30 mit integrierten Photovoltaik-Chips und Reflektoren auf, welche auf einer als Folie ausgebildeten Leiterplatte bzw. Kontaktschicht 14 als oberflächenmontierte Bauteile aufgelötet sind.

FIG. 12 zeigt ein Linsenarray 1200 gemäss einer Ausführungsform der Erfindung mit einer Vielzahl flächig in einer Ebene angeordneten Kondensorlinsen 41. Das Linsenarray 1200 kann z.B. mittels Spritzgiessen aus transparentem Kunststoff vorgefertigt werden. Die einzelnen Kondensorlinsen 41 sind mit dünnen Stegen 41a verbunden. Das so vorgefertigte Linsenarray kann gemäss einer Ausführungsform an der Unterseite der äusseren Scheibe 11 befestigt werden, z.B. durch Kleben.

FIG. 13 zeigt ein Array 1300 gemäss einer Ausführungsform der Erfindung mit einer Vielzahl flächig in einer Ebene angeordneten Umlenkoptiken 50. Die Umlenkoptiken 50 sind exemplarisch durch Kreise dargestellt. Das Array 1300 kann z.B. mittels Spritzgiessen aus transparentem Kunststoff vorgefertigt werden. Die einzelnen Umlenkoptiken 50 sind mit dünnen Stegen 50a verbunden. Das so vorgefertigte Array 1300 kann gemäss einer Ausführungsform an der inneren Scheibe 12 befestigt werden, z.B. durch Kleben.

Gemäss einer anderen Ausgestaltung kann das vorgefertigte Linsenarray 1100 und das vorgefertigte Array 1300 jeweils an dem Photovoltaik-Chip Array 1200 befestigt werden und danach zwischen den Scheiben 11, 12 als vorgefertigtes Gesamtmodul befestigt werden.

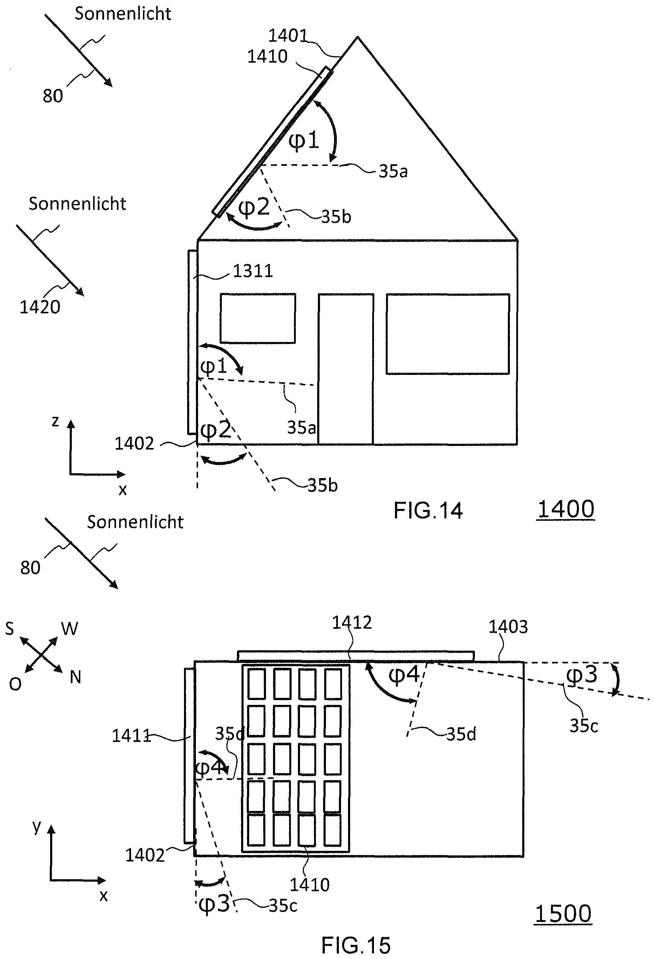

FIG. 14 zeigt eine Seitenansicht eines Gebäudes bzw. Hauses 1400. Das Gebäude 1400 weist auf einem schrägen Dach 1401 ein Photovoltaikbauteil 1410 und auf einer senkrechten Seitenwand 1402 ein Photovoltaikbauteil 1411 auf, welche wie die oben beschriebenen Photovoltaikbauteile 10 ausgestaltet sein können.

FIG. 15 zeigt eine Draufsicht des Gebäudes 1400. Hier ist zu erkennen, dass das Gebäude 1400 zusätzlich zu dem Photovoltaikbauteil 1410 und dem Photovoltaikbauteil 1411 ein weiteres Photovoltaikbauteil 1412 auf der Rückwand 1403 aufweist.

In den Figuren 14 und 15 ist der Sonnenstand 80 in exemplarischer Weise dargestellt, z.B. zu der Mittagszeit.

Zudem sind in der Figur 14 der erste Winkel ϕ1 und der zweite Winkel ϕ2 der Reflektoren 23 der einzelnen Photovoltaikbauteile 1410 und 1411 in exemplarischer Weise mittels gestrichelter Linien dargestellt.

Darüber hinaus sind in der Figur 15 der dritte Winkel ϕ3 und der vierte Winkel ϕ4 der Reflektoren 23 der einzelnen Photovoltaikbauteile 1410 und 1412 in exemplarischer Weise mittels gestrichelter Linien dargestellt.

Die Winkel ϕ1, ϕ2, ϕ3 und ϕ4 beziehen sich dabei wieder auf die Winkel der Reflexionsflächen der in die Gehäuse 30 integrierten Reflektoren 23 der Konzentrator-Photovoltaikmodule der einzelnen Photovoltaikbauteile.

In dem Beispiel der Figuren 14 und 15 weisen die einzelnen Photovoltaikbauteile 1410, 1411 und 1412 jeweils unterschiedliche Kombinationen der einzelnen Winkel ϕ1, ϕ2, ϕ3 und ϕ4 auf. Dadurch ist es möglich, die jeweilige Einbausituation der Systeme 1410, 1411 und 1412 zu berücksichtigen und die Winkel ϕ1, ϕ2, ϕ3 und ϕ4 optimal an den Sonnenstand bzw. Sonnenverlauf anzupassen, um eine maximale Konzentrationswirkung bzw. Verstärkung des Reflektors 23 zu erzielen.

Der erste Winkel ϕ1 und der zweite Winkel ϕ2 sind gemäss Ausführungsformen der Erfindung insbesondere so gewählt, dass sie die jeweilige Einbausituation optimal in Bezug auf die Elevation der Sonne berücksichtigen.

Der dritte Winkel ϕ3 und der vierte Winkel ϕ4 sind gemäss Ausführungsformen der Erfindung insbesondere so gewählt, dass sie die jeweilige Einbausituation optimal in Bezug auf den Azimut der Sonne berücksichtigen. So ist in der FIG. 15 auch die Ausrichtung des Hauses in Bezug auf die Himmelsrichtungen dargestellt. Die Hauswand 1402 weist beispielhaft eine Südost-Exposition auf und die Rückwand 1403 eine Südwest-Exposition. Durch geeignete und individuelle Wahl der Winkel ϕ3 und ϕ4 für die Seitenwand 1402 und die Rückwand 1403 kann der Wirkungsgrad des Photovoltaikbauteils verbessert werden.

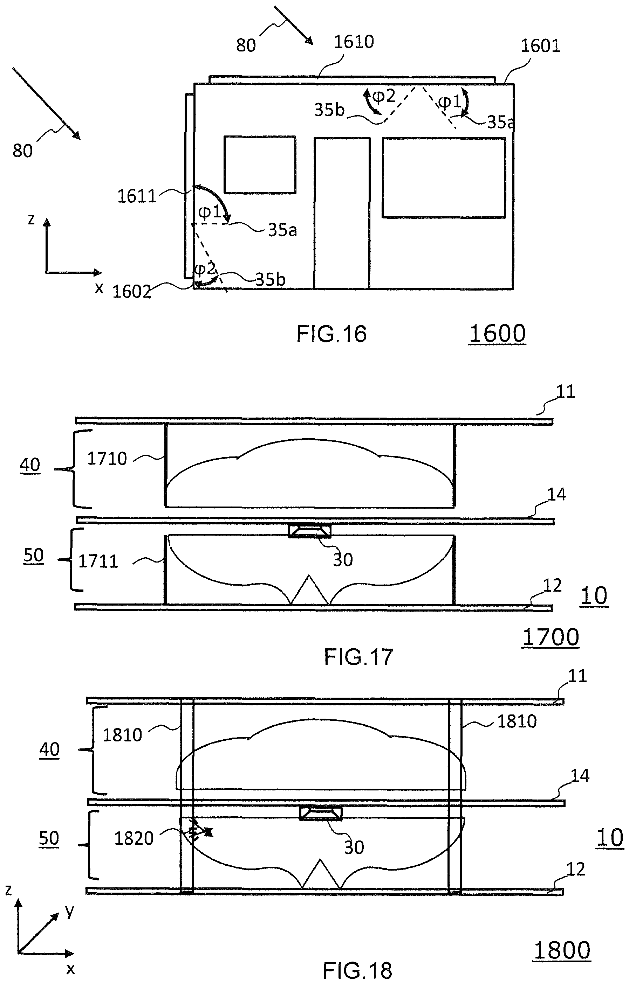

FIG. 16 zeigt eine Seitenansicht eines Hauses 1600 mit einem flachen Dach 1601. Auf dem flachen Dach 1601 ist ein Photovoltaikbauteil 1610 und auf einer senkrechten Seitenwand 1602 ein Photovoltaikbauteil 1611 angebracht.

Der erste Winkel ϕ1 und der zweite Winkel ϕ2 des Photovoltaikbauteils 1610 sind anders gewählt als der erste Winkel ϕ1 und der zweite Winkel ϕ2 des Photovoltaikbauteils 1410 des in der FIG. 14 dargestellten Schrägdachs, um die Reflektorwirkung der Photovoltaikbauteile zu verbessern.

Somit können gemäss Ausführungsformen der Erfindung die Photovoltaikbauteile 10 als energieerzeugende Glas- oder Kunststoffbauteile für Dachsysteme, Flachdächer, Industriedächer, Hausdächer, Fassaden, Fassadenkonstruktionen und/oder als Einfach oder Mehrscheiben-Isoliergläser eingesetzt werden.

Fig. 17 zeigt eine Querschnittsansicht 1700 eines energieerzeugenden Photovoltaikbauteils 10 in einer x-z-Ebene gemäss einer weiteren Ausführungsform der Erfindung. Das energieerzeugende Photovoltaikbauteil 10 ist insbesondere wie in der FIG. 5 beschrieben ausgestaltet. Gemäss diesem Ausführungsbeispiel ist die Kondensoroptik 40 mittels Stegen 1710 an der äusseren Scheibe 11 befestigt bzw. abgestützt ist. Ferner ist die Umlenkoptik 50 mittels Stegen 1711 an der inneren Scheibe 12 befestigt bzw. abgestützt ist. Die Stege können insbesondere aus Kunststoff ausgeführt sein. Gemäss Ausführungsformen können die Stege 1710 und 1711 auch verbunden sein bzw. einstückig ausgebildet sein.

Fig. 18 zeigt eine Querschnittsansicht 1800 eines energieerzeugenden Photovoltaikbauteils 10 in einer x-z-Ebene gemäss einer weiteren Ausführungsform der Erfindung. Das energieerzeugende Photovoltaikbauteil 10 ist insbesondere wie in der FIG. 5 beschrieben ausgestaltet. Gemäss diesem Ausführungsbeispiel sind die Kondensoroptik 40 und die Umlenkoptik 50 mittels Stegen 1810 zwischen der äusseren Scheibe 11 und der inneren Scheibe 12 befestigt bzw. abgestützt ist. Dabei sind die Stege 1810 als Lichtwellenleiter ausgestaltet und dazu konfiguriert, durch die innere Scheibe 12 und die äussere Scheibe 11 einfallendes Licht in die Umlenkvorrichtung 50 zu leiten bzw. auszukoppeln. Hierzu weisen die Lichtwellenleiter 1810 Auskoppelvorrichtungen 1820 auf. Dadurch kann der Wirkungsgrad weiter erhöht werden. Zudem ist es bei einer derartigen Ausführungsform auch möglich, die Umlenkvorrichtung ebenfalls, zumindest teilweise, als Lichtwellenleiter auszugestalten.

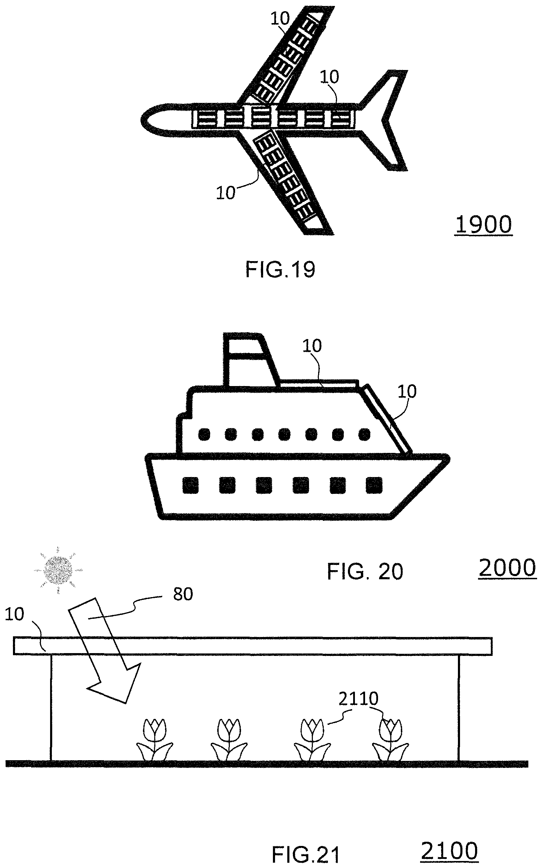

Fig. 19 zeigt ein Flugzeug 1900 mit mehreren in die Aussenhaut des Flugzeugs 1900 integrierten Photovoltaikbauteilen (10).

Fig. 20 zeigt ein Schiff 2000 mit mehreren auf der Oberfläche des Schiffes angeordneten Photovoltaikbauteilen (10).

FIG. 21 zeigt ein Photovoltaikbauteil 10, welches oberhalb einer Agrarfläche 2110 angeordnet ist. Infolge der teiltransparenten Ausgestaltung des Photovoltaikbauteils 10 ist es dadurch möglich, die Agrarflächen 2110 sowohl zur Erzeugung von Solarenergie als auch weiterhin zum Anbau von Pflanzen, Gemüse, Obst etc. zu nutzen.

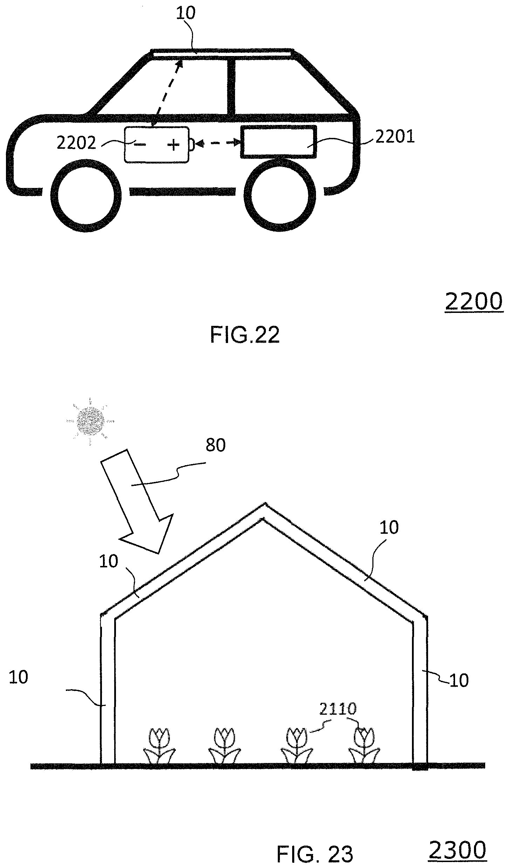

Fig. 22 zeigt ein Automobil 2200 gemäss einer Ausführungsform der Erfindung. Das Automobil 2200 weist eine oder mehrere Photovoltaikbauteile 10 auf, z.B. als Dachfenster bzw. Dachverglasung. Das Automobil kann insbesondere als Elektrofahrzeug oder als Hybridfahrzeug oder als Brennstoffzellenfahrzeug ausgestaltet sein und weist dementsprechend mindestens einen elektrischen Antrieb, z.B. Elektromotor 2201 und mindestens eine Batterie 2202 auf. Die Photovoltaikbauteile 10 sind beispielsweise zum Laden der Batterie 2202 konfiguriert. Gemäss einer weiteren Ausgestaltung der Erfindung kann das Fahrzeug 2200 auch ohne elektrischen Antrieb ausgestaltet sein und z.B. nur einen Verbrennermotor oder einen anderen Antrieb aufweisen. In einem solchen Fall können die Photovoltaikbauteile 10 dazu verwendet werden, die Solarenergie ins Bordnetz einzuspeisen und somit die elektrischen Verbraucher zu versorgen oder eine Niedervolt-Batterie zum Betrieb der Fahrzeugelektrik aufzuladen.

FIG. 23 zeigt ein Gewächshaus 2300, dessen Dachflächen und Seitenflächen durch Photovoltaikbauteile 10 gemäss Ausführungsformen der Erfindung gebildet sind. Infolge der teiltransparenten Ausgestaltung der Photovoltaikbauteile 10 ist es dadurch möglich, die Gewächshäuser sowohl zur Erzeugung von Solarenergie als auch zum Anbau von Pflanzen, Gemüse, Obst etc. zu nutzen.

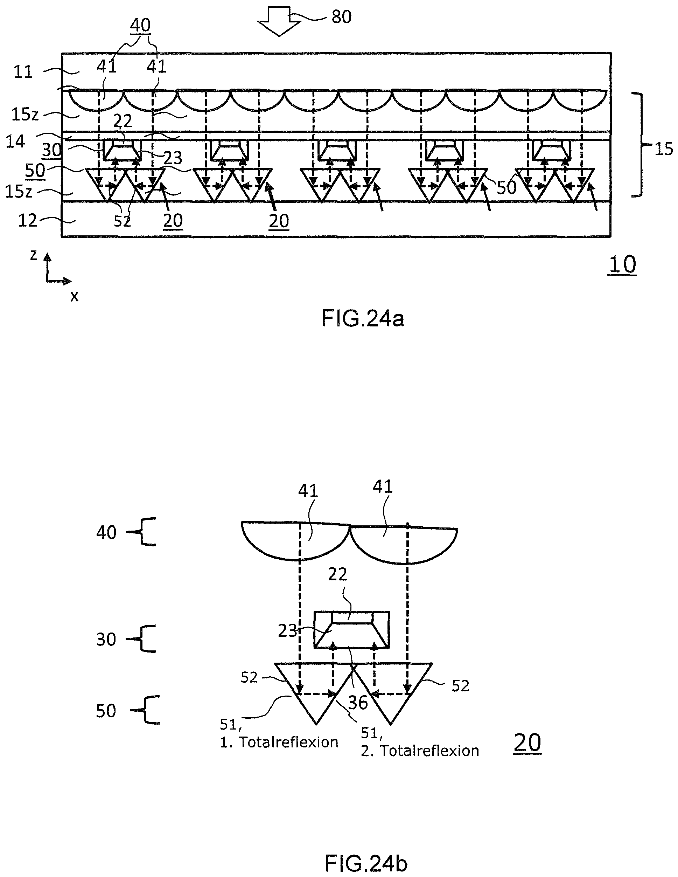

FIG. 24a zeigt eine Querschnittsansicht eines energieerzeugenden Photovoltaikbauteils 10 in einer x-z-Ebene gemäss einer weiteren Ausführungsform der Erfindung. Das Photovoltaikbauteil 10 entspricht zu grossen Teilen dem Photovoltaikbauteil 10 von FIG. 1a. Bei der Ausführungsform der FIG. 24a weisen die Umlenkoptiken 50 jeweils zwei Prismen 52 auf, welche das einfallende Licht mittels zweimaliger Totalreflexion in Richtung auf das oberflächenmontierbare Gehäuse 30 umlenken. Dabei wird die Richtung des einfallenden Lichts umgekehrt. Die Prismen 52 können daher auch als Umkehrprismen bezeichnet werden.

FIG. 24b zeigt eine vergrösserte Darstellung eines Konzentrator-Photovoltaik-Moduls 20 gemäss einer Ausführungsform der Erfindung mit einem exemplarischen Strahlengang. Die Kondensorlinsen 41 der Kondensoroptik 40 fokussieren das einfallende Licht auf erste Umlenkbereiche 51a der Prismen 52. Dann wird das einfallende Licht mittels Totalreflexion von den ersten Umlenkbereichen 51a in Richtung auf zweite Umlenkbereiche 51b reflektiert. Dort findet eine erneute (zweite) Totalreflexion statt in Richtung auf das oberflächenmontierbare Gehäuse 30, insbesondere auf deren transparente Abdeckung. In der Fig. 24b ist nur der parallel einfallende Mittelstrahl gezeigt. Die Prismen 52 sind vorzugsweise so ausgelegt, das auch etwas schräg einfallende Strahlen in Richtung auf das oberflächenmontierbare Gehäuse 30 umgelenkt werden.

Gemäss weiteren Ausgestaltungen der Erfindung können die Photovoltaikbauteile 10 auch in Baufahrzeuge, Agrarfahrzeuge, Züge oder Container integriert oder angebaut sein.

Während in der vorliegenden Anmeldung bevorzugte Ausführungen der Erfindung beschrieben sind, ist klar darauf hinzuweisen, dass die Erfindung nicht auf diese beschränkt ist und in auch anderer Weise innerhalb des Umfangs der folgenden Ansprüche ausgeführt werden kann.

## Patentansprüche

1. Photovoltaikbauteil (10), aufweisend,
eine äussere Scheibe (11); und
eine innere Scheibe (12);
**dadurch gekennzeichnet, dass**
zwischen der äusseren Scheibe (11) und der inneren Scheibe (12) eine energieerzeugende Schicht (15) mit einer Mehrzahl von Konzentrator-Photovoltaikmodulen (20) angeordnet ist, wobei die Konzentrator-Photovoltaik-Module (20) aufweisen
eine Kondensoroptik (40) als primäre Optik;
eine teiltransparente Umlenkoptik (50) als sekundäre Optik; und
einen Photovoltaik-Chip (22), der in ein oberflächenmontierbares Gehäuse (30) integriert ist, wobei das oberflächenmontierbare Gehäuse (30) eine transparente Abdeckung (36) und einen integrierten Reflektor (23) als tertiäre Optik aufweist; wobei
die Kondensoroptik (40) zwischen der äusseren Scheibe (11) und dem Photovoltaik-Chip (22) angeordnet ist;
die teiltransparente Umlenkoptik (50) zwischen dem Photovoltaik-Chip (22) und der inneren Scheibe (12) angeordnet ist; und
die transparente Abdeckung (36) und eine Eintrittsöffnung (23a) des integrierten Reflektors (23) der inneren Scheibe (12) zugewandt sind, wobei
die Kondensoroptik (40) dazu konfiguriert ist, durch die äussere Scheibe (12) einfallendes Sonnenlicht auf einen oder mehrere Umlenkbereiche (51) der Umlenkoptik (50) zu fokussieren;
die Umlenkoptik (50) dazu konfiguriert ist, das von der Kondensoroptik (40) auf die einen oder die mehreren Umlenkbereiche (51) fokussierte Sonnenlicht in den integrierten Reflektor (23) umzulenken; und
der Reflektor (23) dazu konfiguriert ist, das von der Umlenkvorrichtung (50) umgelenkte Sonnenlicht auf den Photovoltaik-Chip (22) zu konzentrieren.

2. Photovoltaikbauteil nach Anspruch 1, **dadurch gekennzeichnet, dass** wenigstens einer der einen oder der mehreren Umlenkbereiche (51) seitlich versetzt zu dem oberflächenmontierbaren Gehäuse (30) angeordnet ist.

3. Photovoltaikbauteil nach einem der vorhergehenden Ansprüche, **dadurch gekennzeichnet, dass**
die Umlenkvorrichtung (50) dazu konfiguriert ist, eine mehrstufige Umlenkung des Sonnenlichts in den integrierten Reflektor (23) vorzunehmen.

4. Photovoltaikbauteil nach einem der vorhergehenden Ansprüche, wobei
der eine oder die mehreren Umlenkbereiche (51) als reflektierende Flächen ausgebildet sind.

5. Photovoltaikbauteil nach einem der vorhergehenden Ansprüche, **dadurch gekennzeichnet, dass** die Umlenkvorrichtung (50) einen Lichtwellenleiter aufweist.

6. Photovoltaikbauteil nach einem der vorhergehenden Ansprüche, **dadurch gekennzeichnet, dass** das Photovoltaik-Bauteil (10) eine Lichtdurchlässigkeit von mehr als 50%, insbesondere von mehr als 75% aufweist.

7. Photovoltaikbauteil nach einem der vorhergehenden Ansprüche, **dadurch gekennzeichnet, dass** der Umlenkbereich bzw. die Umlenkbereiche (51) der Umlenkoptik maximal 20%, insbesondere maximal 15%, der horizontalen Querschnittsfläche des Photovoltaik-Bauteils (10) abdecken.

8. Photovoltaikbauteil nach einem der vorhergehenden Ansprüche, **dadurch gekennzeichnet, dass** die Kondensoroptik (40) der Konzentrator-Photovoltaik-Module (20) mehrere Kondensorlinsen (41) aufweist, welche nebeneinander angeordnet sind;
wobei die Kondensorlinsen (41) insbesondere rotationssymmetrisch zu einer zentralen Achse des Konzentrator-Photovoltaik-Moduls angeordnet sind.

9. Photovoltaikbauteil nach einem der vorhergehenden Ansprüche, **dadurch gekennzeichnet, dass** die Kondensoroptik (40) der Konzentrator-Photovoltaik-Module (20) mehrere Kondensorlinsen (41) aufweist, welche nebeneinander angeordnet sind, wobei wenigstens eine der Kondensorlinsen (41b) in einem Winkel, insbesondere einem fünften Winkel, gegenüber einer horizontalen Ebene (410) des Photovoltaikbauteils geneigt angeordnet ist, wobei die Kondensoroptik (40) der Konzentrator-Photovoltaik-Module (20) insbesondere eine erste Kondensorlinse (41b) aufweist, welche in dem fünften Winkel gegenüber der horizontalen Ebene des Photovoltaikbauteils geneigt angeordnet ist und eine zweite Kondensorlinse (41a) aufweist, welche parallel zu der horizontalen Ebene des Photovoltaikbauteils angeordnet ist.

10. Photovoltaikbauteil nach einem der vorhergehenden Ansprüche, **dadurch gekennzeichnet, dass** das Gehäuse (30) eine eine Aufnahmewanne (33) bildende Aussparung (32) mit einem vertieften Bodenabschnitt (34) zur Aufnahme des Photovoltaik-Chips (22) aufweist, wobei
die Aufnahmewanne (33) Seitenwände mit reflektierenden Bereichen (35a, 35b) aufweist, die den Reflektor (23) bilden, wobei
die Aufnahmewanne (33) insbesondere Seitenwände mit wenigstens einem ersten und einem zweiten reflektierenden Bereich (35a, 35b) aufweist, wobei der erste reflektierende Bereich (35a) in einem ersten Winkel (ϕ1) gegenüber einer horizontalen Ebene (38) des Gehäuses (30) ausgerichtet ist und der zweite reflektierende Bereich (35b) in einem zweiten Winkel (ϕ2) gegenüber der horizontalen Ebene (38) des Gehäuses (30) ausgerichtet ist; und
der erste Winkel (ϕ1) unterschiedlich zu dem zweiten Winkel (ϕ2) ist,
wobei die Aufnahmewanne (33) insbesondere Seitenwände mit einem dritten und einem vierten reflektierenden Bereich (35c, 35d)aufweist, wobei der dritte reflektierende Bereich (35c) in einem dritten Winkel (ϕ3) gegenüber der horizontalen Ebene des Gehäuses (30) ausgerichtet ist und der vierte reflektierende Bereich (35d) in einem vierten Winkel (ϕ4) gegenüber der horizontalen Ebene des Gehäuses (30) ausgerichtet ist, wobei insbesondere der dritte Winkel unterschiedlich zu dem vierten Winkel ist.

11. Photovoltaikbauteil nach einem der vorhergehenden Ansprüche, **dadurch gekennzeichnet, dass**
die Kondensoroptik (40) mittels Stegen (1710) an der äusseren Scheibe (11) befestigt bzw. abgestützt ist; und/oder
die Umlenkoptik (50) mittels Stegen (1711) an der inneren Scheibe (12) befestigt bzw. abgestützt ist, wobei die Stege insbesondere als Lichtwellenleiter (1810) ausgestaltet sind.

12. Photovoltaikbauteil nach einem der vorhergehenden Ansprüche, **dadurch gekennzeichnet, dass** die Umlenkoptik (50) eine oder mehrere Prismen (52) aufweist.

13. Photovoltaikbauteil nach einem der vorhergehenden Ansprüche, **dadurch gekennzeichnet, dass** das Photovoltaikbauteil (10) als energieerzeugendes Bauteil für Dachsysteme, Flachdächer, Industriedächer, Hausdächer, Fassaden, Fassadenkonstruktionen und/oder als Einfach oder Mehrfach-Isolierglas für Gebäude ausgestaltet ist.

14. Vorrichtung mit einem oder mehreren Photovoltaikbauteilen (10) nach einem der vorhergehenden Ansprüche, wobei die Vorrichtung insbesondere ein Fahrzeug, ein Container, ein Gebäude oder ein Gewächshaus ist.

15. Verwendung eines Photovoltaikbauteils nach einem der Ansprüche 1 bis 13 zum Einbau oder Anbau in bzw. an ein Gebäude, ein Fahrzeug, einen Container, ein Gewächshaus sowie andere Vorrichtungen oder zum Anbringen auf Agrarflächen.

## Claims

1. Photovoltaic component (10), comprising,
an outer pane (11); and
an inner pane (12);
**characterized in that**
an energy-generating layer (15) comprising a plurality of concentrator photovoltaic modules (20) is arranged between the outer pane (11) and the inner pane (12), the concentrator photovoltaic modules (20) comprising
a condenser optic (40) as a primary optic;
a partially transparent deflection optic (50) as a secondary optic; and
a photovoltaic chip (22) integrated into a surface mountable housing (30), the surface mountable housing (30) having a transparent cover (36) and an integrated reflector (23) as a tertiary optic; wherein
the condenser optic (40) is arranged between the outer pane (11) and the photovoltaic chip (22);
the partially transparent deflection optic (50) is arranged between the photovoltaic chip (22) and the inner pane (12); and
the transparent cover (36) and an inlet opening (23a) of the integrated reflector (23) face the inner pane (12), wherein
the condenser optic (40) is configured to focus sunlight entering through the outer pane (12) onto one or more deflection regions (51) of the deflection optic (50);
the deflection optic (50) is configured to deflect the sunlight focused by the condenser optic (40) onto the one or more deflection regions (51) into the integrated reflector (23); and
the reflector (23) is configured to concentrate the sunlight deflected by the deflector (50) onto the photovoltaic chip (22).

2. Photovoltaic component according to claim 1, **characterized in that** at least one of the one or the plurality of deflection regions (51) is arranged laterally offset to the surface-mountable housing (30).

3. Photovoltaic component according to any one of the preceding claims, **characterized in that**
the deflection optic (50) is configured to perform a multi-stage deflection of the sunlight into the integrated reflector (23).

4. Photovoltaic component according to any one of the preceding claims, wherein
the one or more deflection regions (51) are designed as reflective surfaces.

5. Photovoltaic component according to any one of the preceding claims, **characterized in that** the deflection optic (50) comprises an optical fiber.

6. Photovoltaic component according to any one of the preceding claims, **characterized in that** the photovoltaic component (10) has a light transmission of more than 50%, in particular more than 75%.

7. Photovoltaic component according to any one of the preceding claims, **characterized in that** the deflection region or the deflection regions (51) of the deflection optic cover a maximum of 20%, in particular a maximum of 15%, of the horizontal cross-sectional area of the photovoltaic component (10) .

8. Photovoltaic component according to any one of the preceding claims, **characterized in that** the condenser optic (40) of the concentrator photovoltaic modules (20) comprises a plurality of condenser lenses (41) which are arranged side by side;
wherein the condenser lenses (41) are arranged in particular rotationally symmetrically to a central axis of the concentrator photovoltaic module.

9. Photovoltaic component according to any one of the preceding claims, **characterized in that** the condenser optic (40) of the concentrator photovoltaic modules (20) comprises a plurality of condenser lenses (41) which are arranged side by side, wherein at least one of the condenser lenses (41b) is arranged inclined at an angle, in particular a fifth angle, with respect to a horizontal plane (410) of the photovoltaic component, wherein the condenser optic (40) of the concentrator photovoltaic modules (20) comprises in particular a first condenser lens (41b) which is arranged inclined at the fifth angle with respect to the horizontal plane of the photovoltaic component and a second condenser lens (41a) which is arranged parallel to the horizontal plane of the photovoltaic component.

10. Photovoltaic component according to any one of the preceding claims, **characterized in that** the housing (30) comprises a recess (32) forming a receiving tray (33) with a recessed bottom portion (34) for receiving the photovoltaic chip (22), wherein
the receiving tray (33) has side walls with reflective regions (35a, 35b) which form the reflector (23), wherein
the receiving tray (33) in particular has side walls with at least a first and a second reflective region (35a, 35b), the first reflective region (35a) being oriented at a first angle (ϕ1) with respect to a horizontal plane (38) of the housing (30) and the second reflective region (35b) being oriented at a second angle (ϕ2) with respect to the horizontal plane (38) of the housing (30); and
the first angle (ϕ1) is different from the second angle (ϕ2),
wherein the receiving tray (33) in particular has side walls with a third and a fourth reflective region (35c, 35d), wherein the third reflective region (35c) is oriented at a third angle (ϕ3) with respect to the horizontal plane of the housing (30) and the fourth reflective region (35d) is oriented at a fourth angle (ϕ4) with respect to the horizontal plane of the housing (30), wherein the third angle is in particular different from the fourth angle.

11. Photovoltaic component according to any one of the preceding claims, **characterized in that**
the condenser optic (40) is fixed or supported on the outer pane (11) by means of webs (1710); and/or
the deflection optic (50) is fixed or supported on the inner pane (12) by means of webs (1711), the webs being designed in particular as optical fibers (1810).

12. Photovoltaic component according to one of the preceding claims, **characterized in that** the deflection optic (50) comprises one or more prisms (52).

13. Photovoltaic component according to any one of the preceding claims, **characterized in that** the photovoltaic component (10) is designed as an energy-generating component for roof systems, flat roofs, industrial roofs, house roofs, facades, facade constructions and/or as single or multiple insulating glass for buildings.

14. Device with one or more photovoltaic components (10) according to any one of the preceding claims, wherein the device is in particular a vehicle, a container, a building or a greenhouse.

15. Use of a photovoltaic component according to any one of claims 1 to 13 for installation or attachment in or on a building, a vehicle, a container, a greenhouse as well as other devices or for arranging on agricultural land.

## Revendications

1. Composant photovoltaïque (10), comprenant,
un disque extérieur (11) ; et
un disque intérieur (12) ;
**caractérisé en ce que**
entre le disque extérieur (11) et le disque intérieur (12) est disposée une couche génératrice d'énergie (15) avec une pluralité de modules photovoltaïques à concentrateur (20), les modules photovoltaïques à concentrateur (20) comprenant
une optique de condenseur (40) comme optique primaire ;
une optique de déviation partiellement transparente (50) comme optique secondaire ; et
une puce photovoltaïque (22) intégrée dans un boîtier (30) pouvant être monté en surface, le boîtier (30) pouvant être monté en surface comprenant un couvercle transparent (36) et un réflecteur intégré (23) en tant qu'optique tertiaire ; dans lequel
l'optique de condenseur (40) est placée entre le disque extérieur (11) et la puce photovoltaïque (22) ;
l'optique de déviation partiellement transparente (50) est disposée entre la puce photovoltaïque (22) et le disque intérieur (12) ; et
le couvercle transparent (36) et une ouverture d'entrée (23a) du réflecteur intégré (23) sont orientés vers le disque intérieur (12), dans lequel
l'optique de condenseur (40) est configurée pour focaliser la lumière solaire incidente à travers le disque extérieur (12) sur une ou plusieurs zones de déviation (51) de l'optique de déviation (50) ;
l'optique de déviation (50) est configurée pour dévier la lumière solaire focalisée par l'optique de condenseur (40) sur une ou plusieurs zones de déviation (51) dans le réflecteur intégré (23) ; et
le réflecteur (23) est configuré pour concentrer la lumière solaire déviée par le dispositif de déviation (50) sur la puce photovoltaïque (22).

2. Composant photovoltaïque selon la revendication 1, **caractérisé en ce qu'**au moins une desdites une ou plusieurs zones de déviation (51) est décalée latéralement par rapport au boîtier (30) pouvant être monté en surface.

3. Composant photovoltaïque selon l'une des revendications précédentes, **caractérisé en ce que**
le dispositif de déviation (50) est configuré pour effectuer une déviation à plusieurs niveaux de la lumière solaire dans le réflecteur intégré (23).

4. Composant photovoltaïque selon l'une des revendications précédentes, dans lequel
l'une ou les plusieurs zones de déviation (51) sont configurées comme des surfaces réfléchissantes.

5. Composant photovoltaïque selon l'une des revendications précédentes, **caractérisé en ce que** le dispositif de déviation (50) comporte un guide d'onde optique.

6. Composant photovoltaïque selon l'une des revendications précédentes, **caractérisé en ce que** le composant photovoltaïque (10) présente une transmission de lumière supérieure à 50%, en particulier supérieure à 75%.

7. Composant photovoltaïque selon l'une des revendications précédentes, **caractérisé en ce que** la ou les zones de déviation (51) de l'optique de déviation couvrent au maximum 20%, en particulier au maximum 15%, de la surface de la section horizontale du composant photovoltaïque (10).

8. Composant photovoltaïque selon l'une des revendications précédentes, **caractérisé en ce que** l'optique de condenseur (40) des modules photovoltaïques à concentrateur (20) comporte plusieurs lentilles de condenseur (41) disposées côte à côte ;
les lentilles de condenseur (41) étant en particulier disposées avec une symétrie de révolution par rapport à un axe central du module photovoltaïque à concentration.

9. Composant photovoltaïque selon l'une des revendications précédentes, **caractérisé en ce que** l'optique de condenseur (40) des modules photovoltaïques à concentrateur (20) comporte plusieurs lentilles de condenseur (41) disposées côte à côte, au moins l'une des lentilles de condenseur (41b) étant inclinée d'un angle, en particulier d'un cinquième angle, par rapport à un plan horizontal (410) du composant photovoltaïque, dans lequel l'optique de condenseur (40) des modules photovoltaïques à concentrateur (20) comprend en particulier une première lentille de condenseur (41b) inclinée selon le cinquième angle par rapport au plan horizontal du composant photovoltaïque et une deuxième lentille de condenseur (41a) disposée parallèlement au plan horizontal du composant photovoltaïque.

10. Composant photovoltaïque selon l'une des revendications précédentes, **caractérisé en ce que** le boîtier (30) présente un évidement (32) formant un bac de réception (33) avec une partie de fond en creux (34) pour recevoir la puce photovoltaïque (22), dans lequel
le bac de réception (33) présente des parois latérales avec des zones réfléchissantes (35a, 35b) qui forment le réflecteur (23), dans lequel
le bac de réception (33) comporte en particulier des parois latérales avec au moins une première et une deuxième zone réfléchissante (35a, 35b), la première zone réfléchissante (35a) étant orientée selon un premier angle (ϕ1) par rapport à un plan horizontal (38) du boîtier (30) et la deuxième zone réfléchissante (35b) étant orientée selon un deuxième angle (ϕ2) par rapport au plan horizontal (38) du boîtier (30) ; et
le premier angle (ϕ1) est différent du deuxième angle (ϕ2),
le bac de réception (33) comportant en particulier des parois latérales avec une troisième et une quatrième zones réfléchissantes (35c, 35d), la troisième zone réfléchissante (35c) étant orientée selon un troisième angle (ϕ3) par rapport au plan horizontal du boîtier (30) et la quatrième zone réfléchissante (35d) étant orientée selon un quatrième angle (ϕ4) par rapport au plan horizontal du boîtier (30), en particulier le troisième angle étant différent du quatrième angle.

11. Composant photovoltaïque selon l'une des revendications précédentes, **caractérisé en ce que**
l'optique du condenseur (40) est fixée ou supportée sur le disque extérieur (11) au moyen de barrettes (1710) ; et/ou
l'optique de déviation (50) est fixée ou supportée sur le disque intérieur (12) au moyen de barrettes (1711), les barrettes étant en particulier conçues comme des guides d'ondes lumineuses (1810).

12. Composant photovoltaïque selon l'une des revendications précédentes, **caractérisé en ce que** l'optique de déviation (50) présente un ou plusieurs prismes (52).

13. Composant photovoltaïque selon l'une des revendications précédentes, **caractérisé en ce que** le composant photovoltaïque (10) est conçu comme un composant générateur d'énergie pour des systèmes de toitures, des toitures plates, des toitures industrielles, des toitures de maisons, des façades, des constructions de façades et/ou comme un vitrage isolant simple ou multiple pour des bâtiments.

14. Dispositif comprenant un ou plusieurs composants photovoltaïques (10) selon l'une des revendications précédentes, le dispositif étant notamment un véhicule, un conteneur, un bâtiment ou une serre.

15. Utilisation d'un composant photovoltaïque selon l'une des revendications 1 à 13 pour l'intégration ou le montage dans ou sur un bâtiment, un véhicule, un conteneur, une serre ainsi que d'autres dispositifs ou pour l'application sur des surfaces agricoles.
